# EUROPEAN PATENT SPECIFICATION

(11) **EP 4 454 013 B1**
(45) Date of publication and mention of the grant of the patent: **14.10.2026**
(21) Application number: 22912758.4
(22) Date of filing: 22.12.2022
(51) Int. Cl.: H10W 70/00, H10P 72/70, H10W 70/60, H10W 70/685, H10W 72/90, H10W 90/00, H05K 1/11, H10W 70/67, H10W 72/00, H10P 74/00, H10W 80/00, H10W 72/20, H10W 90/24

(54) **BONDED STRUCTURES WITH INTERCONNECT ASSEMBLIES**
GEBONDETE STRUKTUREN MIT VERBINDUNGSANORDNUNGEN
STRUCTURES LIÉES COMPRENANT DES ENSEMBLES D'INTERCONNEXION

(30) Priority: 23.12.2021 US 202163293299 P
(43) Date of publication of application: 30.10.2024
(73) Proprietor: Adeia Semiconductor Bonding Technologies Inc., San Jose, CA 95134 (US)
(72) Inventor: UZOH, Cyprian, Emeka, San Jose, California 95134 (US); FOUNTAIN, Gaius, Gilman, Jr., San Jose, California 95134 (US); WORKMAN, Thomas, San Jose, California 95134 (US); HABA, Belgacem, San Jose, California 95134 (US); KATKAR, Rajesh, San Jose, California 95134 (US); MIRKARIMI, Laura, Wills, San Jose, California 95134 (US)
(74) Representative: Murgitroyd & Company
(86) International application number: PCT/US2022/082304
(87) International publication number: WO 2023/122771

(56) References cited:
- US-A1- 2010 129 999
- US-A1- 2010 258 952
- US-A1- 2016 327 977
- US-A1- 2018 026 227
- US-A1- 2019 148 269
- US-A1- 2019 206 791
- US-A1- 2019 273 039
- US-A1- 2019 341 350
- US-A1- 2020 013 667
- US-A1- 2021 343 690
- US-B1- 6 410 983

## Description

### BACKGROUND

### Field of the Invention

The field relates to bonded structures and, in particular, to bonded structures with interconnect assemblies.

### Description of the Related Art

Semiconductor elements can be stacked and bonded to one another to form bonded structures. In some devices, for example, semiconductor elements can be directly bonded to one another without an adhesive using hybrid direct bonding techniques. It can be challenging to integrate semiconductor elements of different types or material sets in a package due to, for example, mismatches in coefficient of thermal expansion (CTE). Further, it can be challenging to provide communication between stacks of semiconductor elements and to maintain a low profile for the package or device.

US2019/341350 discloses dielets on flexible and stretchable packaging for microelectronics. Configurations of flexible, stretchable, and twistable microelectronic packages are achieved by rendering chip layouts, including processors and memories, in distributed collections of dielets implemented on flexible and/or stretchable media. High-density communication between the dielets is achieved with various direct-bonding or hybrid bonding techniques that achieve high conductor count and very fine pitch on flexible substrates.

US2016/327977 discloses an integrated circuit (IC) package including a flexible substrate. The flexible substrate has a plurality of dies coupled therewith. The IC package includes a first encapsulation material, having a first rigidity, disposed on the flexible substrate to at least partially encapsulate each die of the plurality dies. The IC package may further include a second encapsulation material, having a second rigidity, disposed on the flexible substrate.

### SUMMARY

According to an aspect of the present disclosure, there is provided a bonded structure according to claim 1. Further aspects/features related to embodiments of the bonded structure are recited in the dependent claims.

### BRIEF DESCRIPTION OF THE DRAWINGS

The detailed description is set forth with reference to the accompanying figures. The use of the same numbers in different figures indicates similar or identical items

For this discussion, the devices and systems illustrated in the figures are shown as having a multiplicity of components. Various implementations of devices and/or systems, as described herein, may include fewer components and remain within the scope of the disclosure. Alternatively, other implementations of devices and/or systems may include additional components, or various combinations of the described components, and remain within the scope of the disclosure
FIG. 1 depicts a schematic side sectional view of a conventional package in which a logic die is mounted to a package substrate, and memory die(s) are mounted to the logic die.
FIGS. 2A-B depict a schematic side sectional view of stacked and bonded structures in which laterally spaced dies do not directly communicate with one another.
FIG. 2C depicts a schematic side sectional view of a single layer hybrid interconnect assembly, according to various embodiments.
FIG. 2D depicts a schematic side sectional view of a bonded structure that further includes a single layer hybrid interconnect assembly that connects laterally-adjacent dies.
FIGS. 3A-B depict schematic side sectional views of example interconnect assemblies, according to various embodiments.
FIGS. 4A-H depict schematic side sectional views of example bonded structures that utilize interconnect assemblies, according to various embodiments.
FIGS. 5A-5D schematically illustrate example applications or devices in which the bonded structures or interconnect assemblies disclosed herein are incorporated.
FIGS. 6A-6V depict schematic side sectional views of a method for forming an interconnect assembly.
FIGS. 7A-7I depict schematic side sectional views of examples of a dual damascene process.
FIGS. 8A-8F depict schematic side sectional views of examples of interconnect assemblies used in bonded structures.
FIGS. 9A-9E depict schematic side sectional views of additional embodiments that utilize a test pad, which can connect to a test circuit disposed in the interconnect assembly.
FIGS. 10A-10H depict schematic side sectional views of additional examples of direct bonded structures with interconnect assemblies.

### DETAILED DESCRIPTION

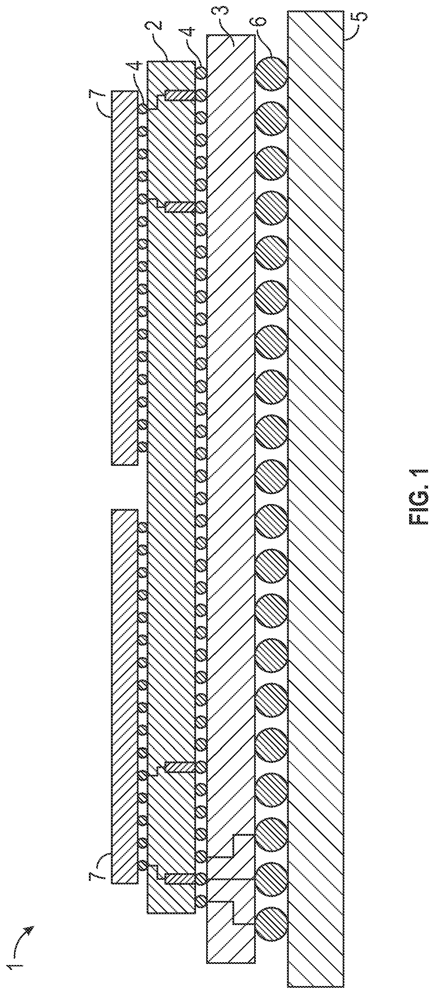

Figure 1 shows a conventional package 1 in which a logic die 2 is mounted to a package substrate 3 in a flip chip configuration, in which solder bumps 4 connect the logic die 2 to the package substrate 3. The package substrate 3, in turn, can be mounted to a system circuit board 5 (such as a printed circuit board, or PCB) by way of solder balls 6. A plurality of memory dies 7 can be mounted to the logic die 2 and laterally spaced from one another. Solder bumps 4 or copper pillars can connect the memory dies 7 to the logic die 2. The use of solder balls 6 and solder bumps 4 in the conventional package 1 shown in Figure 1, can increase the height of the conventional package 1, which may be undesirable for integration into a larger electronic device. Moreover, in conventional packages 1 in which memory dies 7 are spaced apart from one another, it can be challenging to provide electrical communication between the memory dies 7, particularly when the memory dies 7 are stacked on a common support assembly such as the logic die 2 of Figure 1.

Heterogeneous integration of elements of different types or having different material sets can be challenging due to thermal mismatch (e.g., mismatch of coefficient of thermal expansion, or CTE) between different substrates or elements. In various applications, it can be important to provide finely pitched features within organic package substrates 3. In some applications, bridges made out of semiconductor material (e.g., silicon) can be used, but the interconnect bridge still utilizes solder reflow, with can create reliability issues and increase the package height. Flexible package substrates are commonly used for high performance applications (e.g., high frequency, low loss signals), but conventional packages 1 do not utilize direct hybrid bonding to mount elements (e.g., dies) to flexible package substrates).

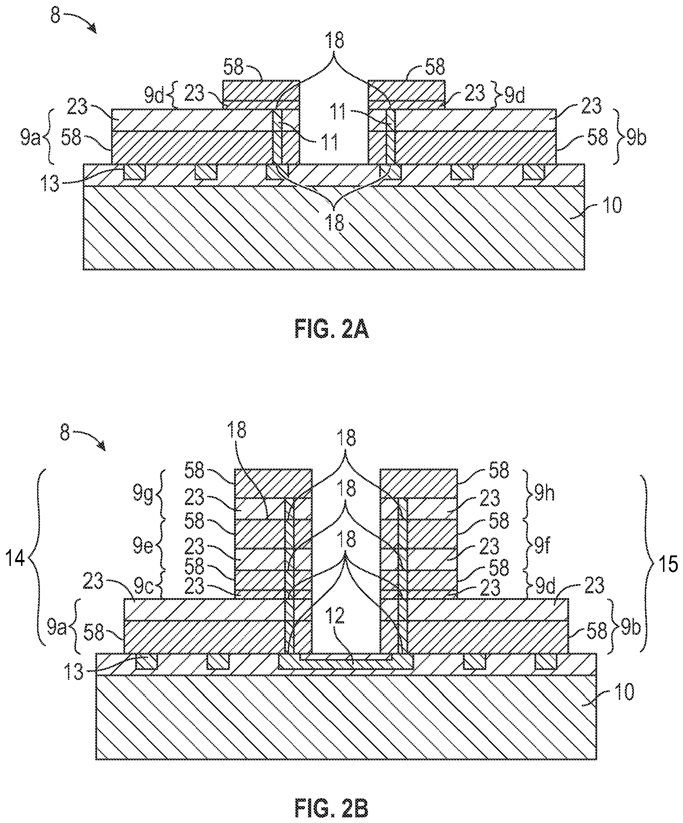

Figures 2A and 2B illustrate a stacked and bonded structures 8 in which laterally spaced dies, or semiconductor elements 9, do not directly communicate with one another. The semiconductor elements 9, include a bulk portion 58 and a bonding layer 23. The bulk portion 58 can comprise a semiconductor portion patterned with devices, such as transistors. For example, in Figures 2A-2B, first 9a and second 9b semiconductor elements (e.g., integrated device dies with active circuitry, such as transistors) can be mounted on and directly bonded to a carrier 10. Within the prior art, the carrier 10 can serve as a support assembly. The carrier 10 can comprise any suitable type of support structure, such as an integrated device die, a wafer, a reconstituted wafer or die, an interposer, etc. Third 9c and fourth 9d semiconductor elements can be mounted on and directly bonded to the first 9a and second 9b semiconductor elements, respectively. Each semiconductor element 9 can include a bonding layer 23 that directly bonds with a bonding layer 23 of another element 9 at a hybrid bonding surface 18 that enables bonding without the use of an adhesive along a bonding interface. As shown in Figure 2B, any suitable number of semiconductor elements 9 can be stacked on one another in either the left stack 14 or the rights stack 15 on the carrier 10. In Figures 2A-2B, the upper elements *(e.g.,* the third 9c, fourth 9d, fifth 9e, sixth 9f, seventh 9g, and eighth 9h semiconductor elements) communicate with the carrier 10 by way of conductive vias 11 (*e.g.,* through substrate vias, or TSVs (e.g., a through-silicon via)). The carrier 10 can provide electrical communication between the first 9a and second 9b semiconductor elements by way of a suitable wiring layer(s) 12, an example of which is depicted in Figure 2B. The bonding layer 23 of the carrier 10 can include additional carrier conductive pads 13 to connect to circuitry in the carrier 10. It should be appreciated that the wiring layer(s) 12 in the carrier 10 and the vias 11may cooperate to provide electrical communication between the third 9c and fourth 9d elements, between the third 9c and second 9b elements, and/or between the first 9a and fourth 9d elements.

The lack of direct communication between the laterally spaced semiconductor elements 9 of Figures 2A-2B can reduce the electrical performance of the bonded structure 8. For example, at least because the signals transmitted between the first 9a and second 9b semiconductor elements (or between other laterally-spaced elements) passes through the intervening carrier 10, there may be longer signal pathways. As another example, as shown in Figure 2B, the electrical routing path between the seventh 9g semiconductor element, which could be configured as a die, on the left stack 14 to the eighth 9h semiconductor element, which could be configured as a die, on the right stack 15 is relatively long, *e.g.,* the signal traverses the routing path through the bonding layers 23 and the fifth 9e, the third 9c, and the first 9a semiconductor elements (by TSVs 11) to the carrier 10. From the carrier 10, the signal traverses the routing path through the wiring layer 12 and to the eighth semiconductor element 9h through the second 9b, fourth 9d, and sixth 9f semiconductor element (by way of TSVs 11). Due to the long pathway between the seventh 9g semiconductor element and the eighth 9h semiconductor element, the signals may experience losses and/or signal lag, which can reduce performance and/or bandwidth.

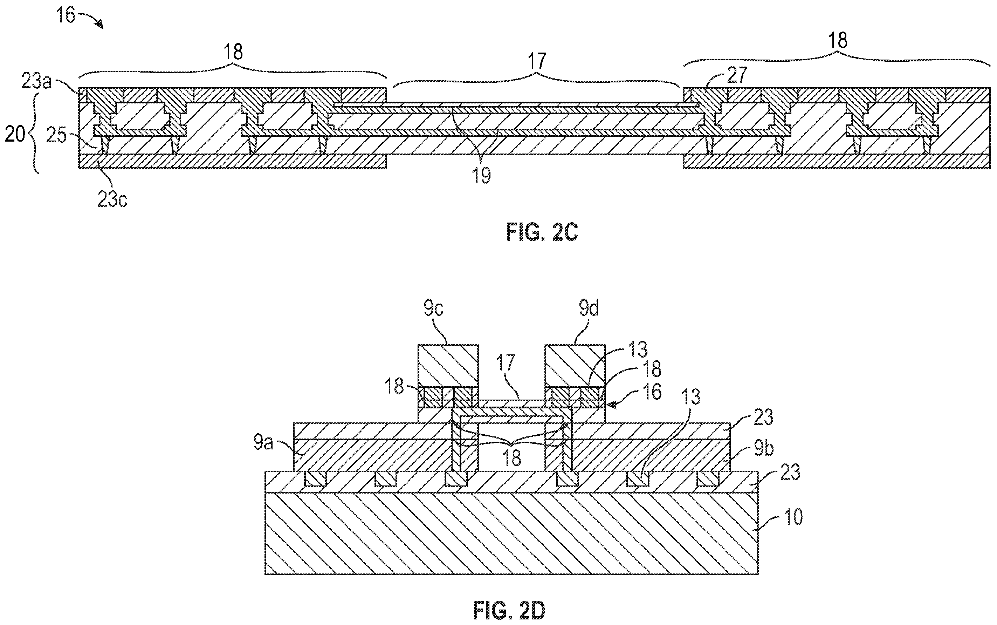

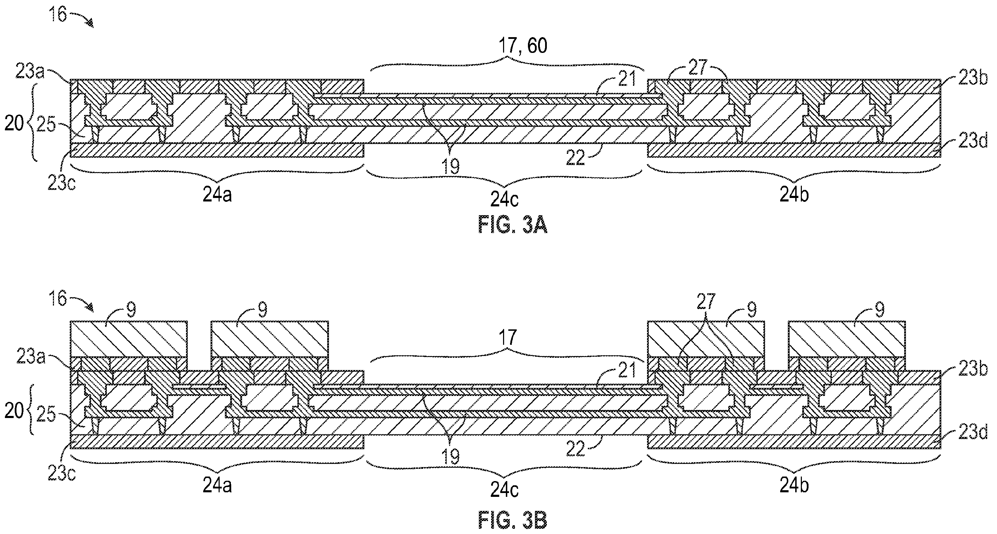

Turning now to Figures 2C-2D, accordingly, various embodiments disclosed herein enable direct communication between laterally-spaced semiconductor elements 9. Figure 2C depicts a schematic side sectional view of a hybrid interconnect assembly 16. As explained below in connection with Figures 3A-3B, the interconnect assembly 16 comprises a flexible unit 17, direct hybrid bonding surfaces 18, conductive traces 19, an insulating substrate 20, nonconductive bonding layers 23, and an insulating base layer 25. Figure 2D depicts a schematic side sectional view of a bonded structure 8 that further includes the hybrid interconnect assembly 16 of Figure 2C. In various embodiments, an interconnect assembly 16, includes a flexible unit 17 and direct hybrid bonding surfaces 18 and is directly bonded to laterally-spaced semiconductor elements 9 to provide a direct electrical connection therebetween. This interconnect assembly 16 can be made with a shorter routing path, thus providing improved electrical performance (Figure 2C and 2D) as compared to the pathways of Figures 2A-2B. In some cases, the routing signals in stacks may not pass through an electrically-intervening semiconductor elements 9 (*e.g.,* the semiconductor elements 9a-f, the carrier 10). Unlike the wiring layer 12 of Figures 2A-2B, in Figures 2C-2D, signals are routed from semiconductor element 9a to semiconductor element 9b through a flexible unit 17 of the interconnect assembly 16.

Figures 3A-3B illustrate example interconnect assemblies 16, according to various embodiments. The interconnect assembly 16 includes an insulating substrate 20 with conductive traces 19 embedded in the insulating substrate 20. The insulating substrate 20 has a first surface 21 and a second surface 22 opposite the first surface 21. The interconnect assembly 16 includes a first inorganic nonconductive bonding layer 23a on a first section 24a of the first surface 21 of the insulating substrate 20. The first inorganic nonconductive bonding layer 23a is prepared for direct bonding (e.g., direct hybrid bonding). The interconnect assembly 16 includes a second inorganic nonconductive bonding layer 23b on a second section 24b of the first surface 21 of the insulating substrate 20. The second section 24b is spaced apart from the first section 24a. The second inorganic nonconductive bonding layer 23b is prepared for direct bonding (e.g., direct hybrid bonding). The first 23a and second 23b inorganic nonconductive bonding layers are disposed at the first surface 21 of the insulating substrate 20. In some embodiments, as shown in Figures 3A-3B, the interconnect assembly 16 can also include third 23c and fourth 23d inorganic nonconductive bonding layers disposed in the first 24a and second 24b sections, respectively, and disposed at the second surface 22 of the insulating substrate 20. In various embodiments, the inorganic nonconductive bonding layers 23 can comprise silicon oxide, silicon nitride, silicon oxynitrocarbide, or any other suitable inorganic nonconductive material. The insulating substrate 20 can comprise a third section 24c including the flexible unit 17 (e.g., flexible section) disposed between the first 24a and second 24b sections. A thickness of the interconnect assembly 16 can be in a range of 1 micron to 50 microns, in a range of 1 micron to 20 microns, or in a range of 1 microns to 3 microns. A thickness of the inorganic bonding layers 23 can be in a range of 300 Angstrom to 50000 Angstrom, for example, in a range of 300 Angstrom to 10000 Angstrom, in a range of 300 Angstrom to 5000 Angstrom, or in a range of 300 Angstrom to 1000 Angstrom.

As shown in Figures 3A-3B, the insulating substrate 20 includes an insulating base layer 25, with the conductive traces 19 at least partially embedded in the insulating base layer 25. As explained herein, the insulating base layer 25 can comprise one insulating layer or a plurality of insulating layers. As shown, the inorganic nonconductive bonding layers 23 is disposed over the insulating base layer 25. The semiconductor elements 9 include a bonding interface at the bonding surface 18 for bonding without the use of an adhesive. The insulating base layer 25 can extend at least partially through the first section 24a, the second section 24b, and the third section 24c including the flexible unit 17. Further, as shown, at least one conductive trace 19 can extend at least partially through the first section 24a, the second section 24b, and the third section 24c including the flexible unit 17. In the illustrated embodiment, the insulating base layer 25 comprises a flexible thickness of an organic material. In various embodiments, the organic material can comprise a polymer or a compliant material, *e.g*., at least one of a liquid crystal polymer (LCP) and/or a polyimide. In various embodiments, a coefficient of thermal expansion (CTE) of the organic layer of the insulating base layer 25 can be less than 15 ppm/°C, for example, less than 12 ppm/°C, or less than 10 ppm/°C in some embodiments. The third section 24c including the flexible unit 17can have a Young's modulus in a range of 2 GPa to 15 GPa, *e.g.,* in a range of 2 GPa to 12 Gpa. In some embodiments, the third section 24c including the flexible unit 17 may comprise a composite material including an organic material with particles or chopped fiber to create a reinforced material. In the illustrated embodiments, the third section 24c including the flexible unit 17 can be bendable without breaking the insulating base layer 25 and without disrupting electrical connectivity of the conductive traces 19. It should be appreciated that, as used herein, the third section 24c including the flexible unit 17 may remain bendable in the bonded structure 8, such as the bonded structure 8 of Figure 2D, or may be fixed so as to be unbendable in the bonded structure 8 (for example, if the bonded structure 8 is overmolded). Accordingly, the third section 24c including the flexible unit 17 can be considered a flexible material in the final structure even though it may be rendered inflexible in a surrounding material, such as a molding compound.

In the illustrated embodiment, the inorganic nonconductive bonding layers 23 can be prepared for direct bonding. For example, the inorganic nonconductive bonding layers 23 can have planarized bonding surfaces 18. The inorganic nonconductive bonding layers 23 can also have activated bonding surfaces 18.

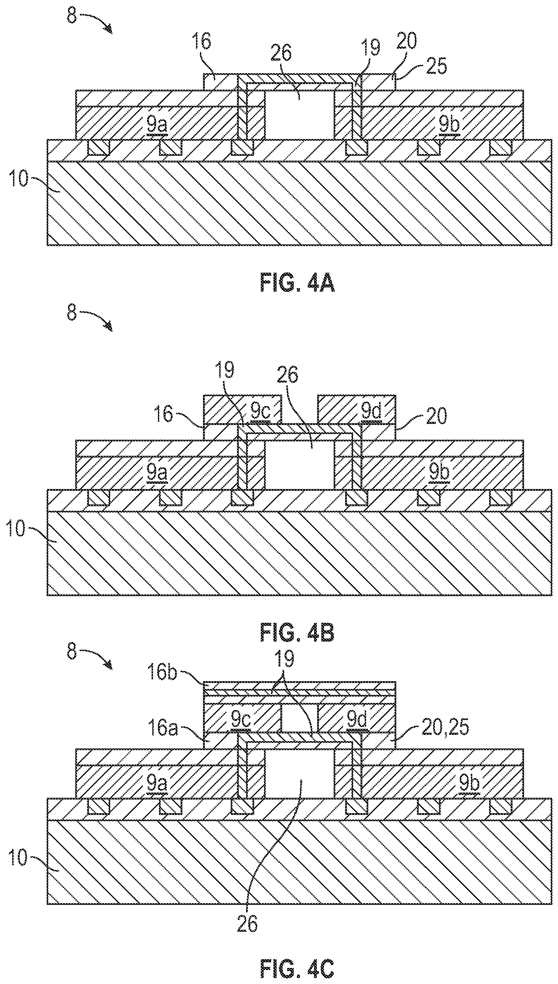

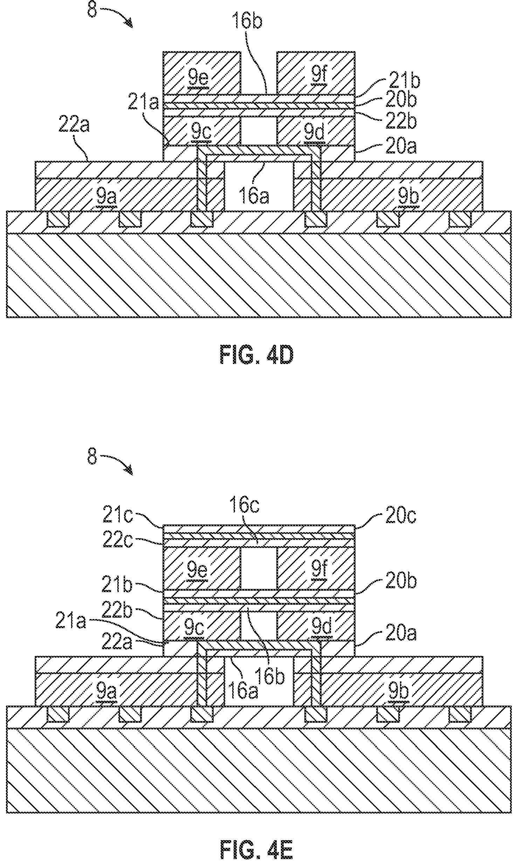

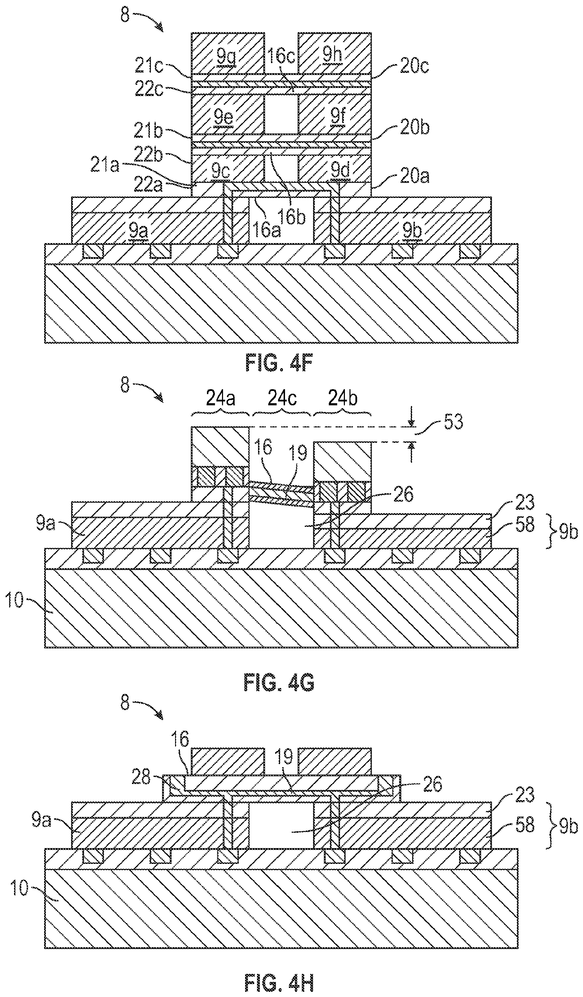

Figures 4A-4H illustrate example bonded structures 8 that can utilize the interconnect assemblies 16 of Figures 3A-3B. For example, the bonded structure 8 includes a first semiconductor element 9a and a second semiconductor 9b element spaced apart from the first semiconductor element 9a by a gap 26 and electrically connected through an interconnect assembly 16a. In some embodiments, the gap 26 comprises a gas (*e.g.,* air) filled gap 26. In other embodiments, a molding compound can be disposed in the gap 26. As shown, the first 9a and second 9b semiconductor elements can be mounted on (*e.g.,* directly bonded to) a carrier 10. As explained above, the bonded structure 8 includes an interconnect assembly 16 comprising an insulating substrate 20 with conductive traces 19. The insulating substrate 20 includes a first section 24a directly bonded to the first semiconductor element 9a, a second section 24b directly bonded to the second semiconductor element 9b, and a third section 24c including the flexible unit 17 disposed between the first and second sections 24a and 24b, the third section 24c including the flexible unit 17 at least partially bridging the gap 26.

As explained above, the insulating substrate 20 comprises an insulating base layer 25 as shown in Figures 3A and 3B, with the conductive traces 19 at least partially embedded in the insulating base layer 25. The insulating base layer 25 can extend at least partially through the first section 24a, the second section 24b, and the third section 24c including the flexible unit 17. At least one conductive trace 19 extends at least partially through the first section 24a, the second section 24b, and the third section 24c including the flexible unit 17 which includes a gap 60 between the first and second sections 24a, 24c. Further, the at least one conductive trace 19 can provide electrical communication between the first 9a and second 9b semiconductor elements. In the illustrated embodiment, the insulating base layer 25 comprises a flexible thickness of an organic material. For example, the organic material can comprise a polymer, such as at least one of a liquid crystal polymer (LCP) and a polyimide. A coefficient of thermal expansion (CTE) of the organic layer can be less than 10 ppm/°C. In other embodiments, the insulating base layer 25 can comprise a flexible thickness of an inorganic material.

As explained above, the first section 24a comprises a first inorganic nonconductive bonding layer 23a disposed over the insulating base layer 25. The second section 24b comprises a second inorganic nonconductive bonding layer 23b disposed over the insulating base layer 25, with the third section 24c including the flexible unit 17 disposed between the first 23a and second 23b inorganic nonconductive bonding layers. As above, the first 23a and second 23b inorganic nonconductive bonding layers comprise planarized and/or activated bonding surfaces. A first surface 21 of the insulating substrate 20 is directly bonded to the first 9a and second 9b semiconductor elements. The insulating substrate 20 has a second surface 22 opposite the first surface 21. The first 23a and second 23b inorganic nonconductive bonding layers are disposed at the first surface 21 of the insulating substrate 20. The first section 24a can comprise a third inorganic nonconductive bonding layer 23c disposed over the insulating base layer 25 at the second surface 22 of the insulating substrate 20. The second section 24b can comprise a fourth inorganic nonconductive bonding layer 23d disposed over the insulating base layer 25 at the second surface 22 of the insulating substrate 20. As shown, the insulating substrate 20 can include a plurality of conductive contact features 27 in Figure 3A and 3B at least partially embedded in the first inorganic nonconductive bonding layer 23a. The first inorganic nonconductive bonding layer 23a can be directly bonded to a nonconductive region of the first semiconductor element 9a without an intervening adhesive. The plurality of conductive contact features 27 can be directly bonded to a plurality of conductive contact features 27 of the first semiconductor element 9a without an intervening adhesive.

As shown in Figures 4D-4F, multiple semiconductor elements 9 can be stacked on one another. Accordingly, in some embodiments, a second surface 22a of the insulating substrate 20a is directly bonded to the first 9a and second semiconductor 9b elements. The first insulating substrate 20a of the first interconnect assembly 16a includes a first surface 21a opposite the second surface 22a. The bonded structure 8 can include a third semiconductor element 9c directly bonded to the first surface 21a of the insulating substrate 20a and a fourth semiconductor element 9d directly bonded to the first surface 21a of the insulating substrate 20a. A second interconnect assembly 16b can include a second insulating substrate 20b with conductive traces 19. The second insulating substrate 20b can include a second section 24b directly bonded to the third semiconductor element 9c, a first section 24a directly bonded to the fourth semiconductor element 9d, and a third section 24c including the flexible unit 17 disposed between the first 24a and second sections 24b.

As shown in Figure 4G, in some embodiments, the interconnect assembly 16 can beneficially connect laterally-spaced semiconductor elements 9 that have different heights. For example, in Figure 4G, the first section 24a can be directly bonded to the first semiconductor element 9a at a first vertical position relative to an upper surface of a support assembly 10 and the second section 24b can be directly bonded to the second semiconductor element 9b at a second vertical position relative to the upper surface of the support assembly 10. The second vertical position can be different by a vertical offset 53 between the bonding surfaces. In Figure 4G, the upper surface of the support assembly comprises a top surface of the first semiconductor element 9a.

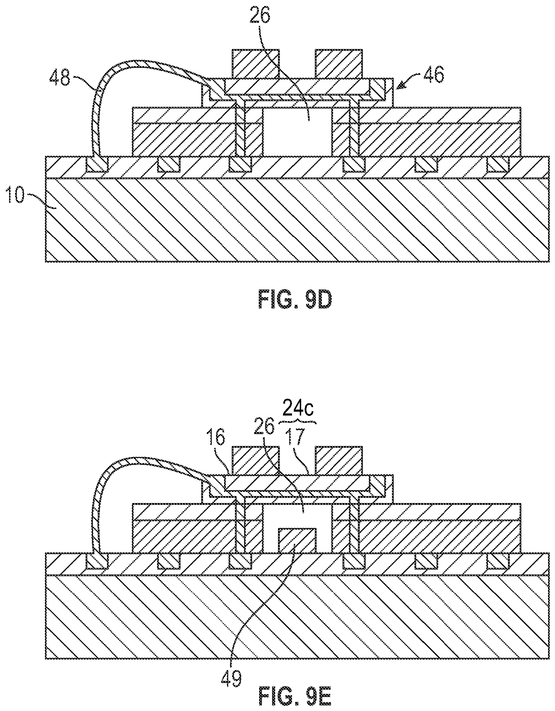

In Figure 4H, the interconnect assembly 16 can include a test circuit 28 connected to at least one of the first 9a and second 9b semiconductor elements. The test circuit 28 can be configured to test a functionality of circuitry in at least one of the first 9a and second 9b semiconductor elements. The test circuit 28 can connect to an external device in any suitable manner. For example, the test circuit 28 can be wire bonded to a carrier 10 to which at least one of the first 9a and second 9b semiconductor elements is mounted, as shown in, *e.g.,* Figures 9D-9E.

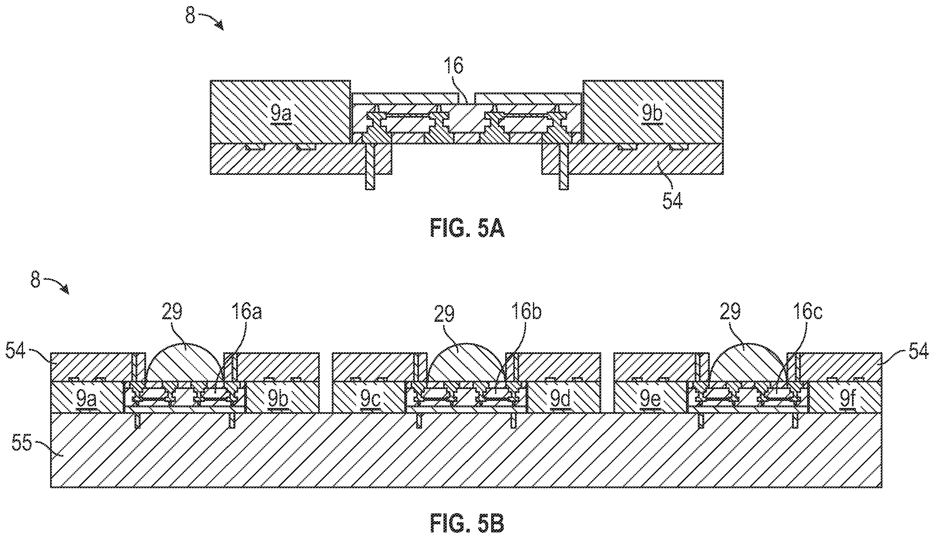

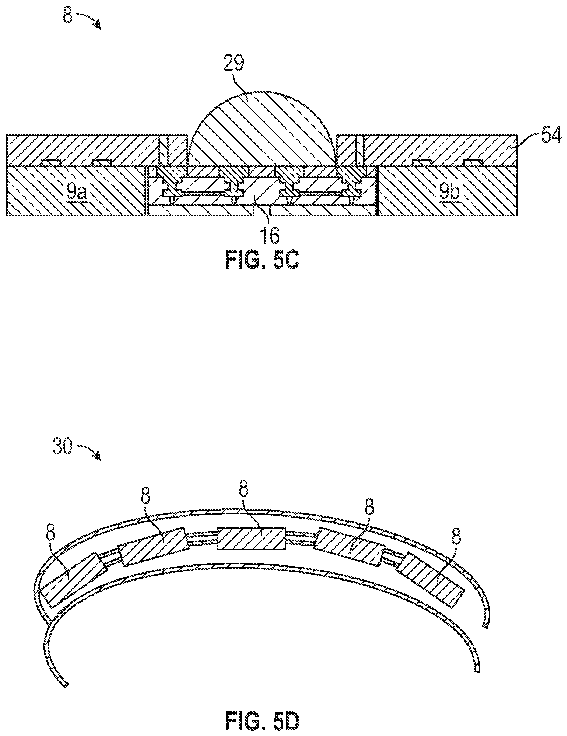

Figures 5A-5D illustrate example applications or devices in which the bonded structures 8 or interconnect assemblies 16 disclosed herein can be incorporated. For example, as shown in Figure 5A, the bonded structure 8 can be incorporated into a wearable consumer device in some embodiments. The interconnect assembly 16 connects two semiconductor devices 9. The semiconductor devices 9 and the interconnect assembly 16 are mounted on (e.g., direct hybrid bonded to) a substrate 54. The bonded structure 8 allows connection between the first 9a and second 9b semiconductor elements while the interconnect assembly is bent or molded into a new shape such as the round shape of a bracelet wristband, necklace, or headband. The semiconductor devices 9 can comprise processors, memories, or sensors to interact with the wearer. In Figures 5B-5C, the bonded structure 8 can include semiconductor elements 9 attached to the interconnect assemblies 16 mounted on (e.g., direct hybrid bonded to) a substrate 54 and can be used in conjunction with optical elements 29 (such as light emitting diodes, or LEDs) which can be connected to a thermoelectric cooler 55 (TEC) in some applications. Figure 5B shows optical elements 29 connected to a TEC 55. Such connected optical elements 29 may be configured as light up jewelry such as light up necklaces or bracelets. In Figure 5D, multiple bonded structures 8 can be connected laterally to one another to form a flexible band structure 30. Accordingly, in Figure 5D, the insulating substrate 20 depicted, for example, in Figures 3A-3B, can include a third section directly bonded to a third semiconductor element and a second flexible section disposed between the second and third sections. Additional semiconductor elements and flexible sections can be daisy-chained together to form a band structure of any suitable length. Such daisy chained bonded structures 8 could be sensors on a wristband configured for heart rate monitoring or other health related monitoring. The daisy chained bonded structures 8 could be configured as sensors in a ring to monitor heart rates or other health related monitoring. Similarly, daisy chained bonded structures 8 could be signal emitters arranged on wearable structures to emit signal locations for tracking the wearer's movements. Direct bonding, such as the examples in Figures 5A-D, can have a higher tolerance of non-planar die and/or height variation in single and multi-die stacks. Additionally, the benefits can include the ability to add a local redistribution layer on all or part of the chip or flex, the ease of integrating substrates with different CTEs, the enhanced direct die to die testing, the reduced signal loss, and the shorter path to connections and lower impedance. In some embodiments, the substrate 54 can serve as a support assembly.

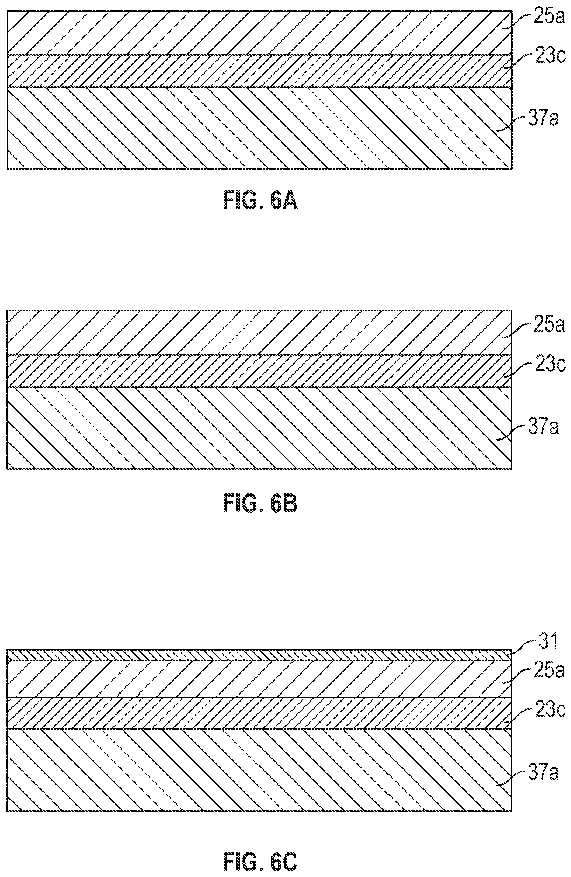

Figures 6A-6V illustrate a method for forming an interconnect assembly 16 according to various embodiments. In Figure 6A, a backside inorganic insulating bonding layer 23c can be provided (*e.g.,* deposited) onto a temporary support structure 37a (also referred to herein as a carrier, handle, or sacrificial substrate The temporary support structure 37a can comprise any suitable type of substrate, such as a semiconductor substrate (*e.g.,* a silicon substrate), a glass substrate, a panel, a substrate which is permanent or temporary, or generally speaking, a carrier, etc. The backside inorganic insulating bonding layer 23c can comprise any suitable type of inorganic insulating material, such as silicon oxide, silicon nitride, silicon oxynitrocarbide, etc. The backside inorganic insulating bonding layer 23c may include a hybrid bonding surface 18 with embedded conductive layers or pads for subsequent use (not shown in Figure 6A). A first insulating base layer 25a can be provided (*e.g.,* deposited on the backside inorganic insulating bonding layer 23c). The first insulating base layer 25a can comprise a sub-layer of the insulating base layer 25 described herein. As explained above, in various embodiments, the first insulating layer 25a can comprise an organic material, such as a polymer. For example, the first insulating layer 25a can comprise polyimide, a liquid crystal polymer (LCP), or any other suitable polymer having a low CTE. This step can include adding a coat of low CTE polymetiric layer < 10ppm/C on the substrate. In Figure 6B, the temporary support structure 37a, bonding layer 23c, and first insulating layer 25a can be cured, for example, using a microwave oven and/or vacuum cure, or a conventional oven. The cure can extract solvents and can reduce the thermal budget and lower stresses in the fabricated structures.

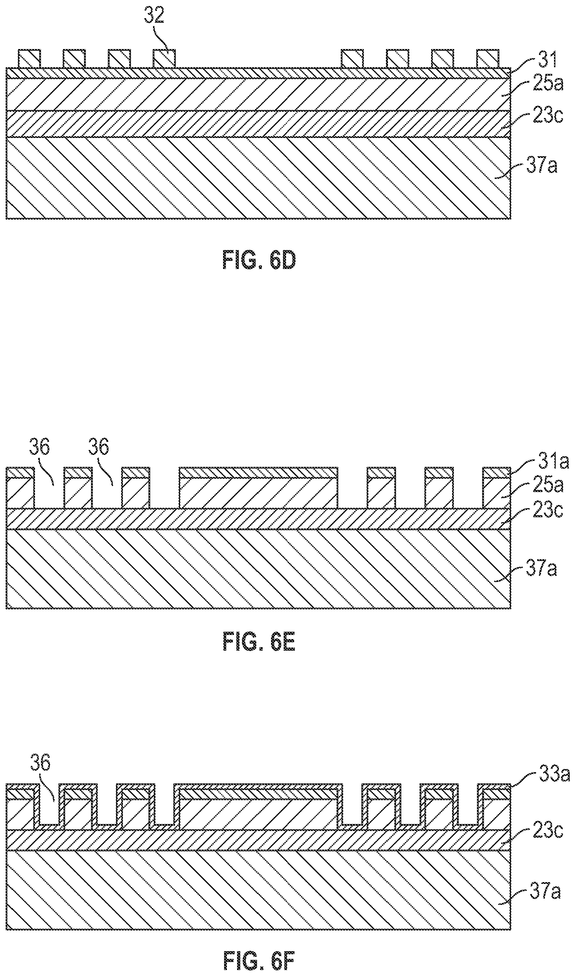

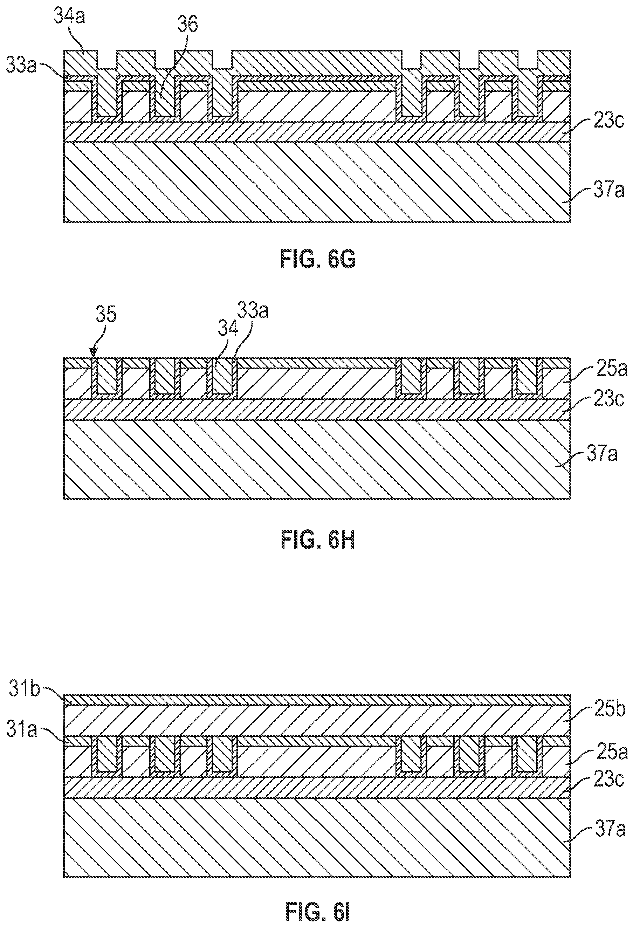

Turning to Figure 6C, a first interlayer dielectric 31a (ILD) layer can be provided (*e.g.,* deposited) on the first insulating layer 25a. The first ILD 31a can comprise a thin dielectric layer, such as a thin layer of silicon nitride or silicon oxide. In various embodiments, the first ILD 31a can comprise one or a plurality of layers. The first ILD 31a can serve as an etch stop in various embodiments. In some embodiments, the first ILD 31a can serve to improve adhesion between the first insulating layer 25a and the second insulating layer 25b (see Figure 6I). In Figure 6D, a photoresist layer 32 can be applied over the first ILD 31a and patterned using lithographic patterning. In Figure 6E, the first ILD 31a and the first insulating layer 25a can be etched in one or more etch processes, such as a reactive ion etching (RIE) process(s) to form single or dual damascene cavities 36. The surfaces of the first insulating layer 25a, including the cavities 36 can be cleaned to remove any residual organic materials. In Figure 6F, a barrier layer 33a can be provided in the cavities 36, and a seed layer (not shown) can be provided over the barrier layer 33a. The barrier layer 33a can comprise any suitable type of barrier that prevents migration of the conductive material 34 (such as copper) into the insulating layer(s) 25. For example, the barrier layer 33a can comprise a conductive barrier material, such as tantalum nitride, titanium nitride, nickel vanadium etc.

Turning to Figure 6G, a conductive material 34a (such as copper) can be provided (*e.g.,* electroplated) in the cavities 36 over the barrier layer 33a. In Figure 6H, a polishing process (*e.g.,* a chemical mechanical polishing, or CMP process) can be performed to planarize the conductive material 34 and remove portions of the barrier layer 33a that overlie the insulating layer 25 leaving a planarized surface 35 of the conductive material 34a.

In some embodiments, a photodefineable polymer (such as polyimide) can be provided to create the metal cavities 36 (*e.g.,* the cavities for the metallic pads) or conductive pads 42. For cavities 36 with lateral dimensions over 2-3 microns, for example, the first ILD layer 31a may be omitted, a coated and soft baked first insulating layer 25a may be patterned via lithographic exposure, and the unwanted regions may be dissolved in a suitable developer. The patterned first insulating layer 25a can be thermally treated at a higher temperature in a vacuum oven or microwave oven, for example, to improve the thermal, mechanical and/or electrical properties of the patterned first insulating layer 25a. A barrier layer 33a can be provided in the cavities 36, and a seed layer can be provided over the barrier layer 33a. A conductive material 34a (such as copper) can be provided (*e.g.,* electroplated) in the cavities 36 over the barrier layer 33a. In Figure 6H, a polishing process (*e.g.,* a chemical mechanical polishing, or CMP process) can be performed to planarize the conductive material 34a and remove portions of the barrier layer 33a that overlie the insulating layer 25a. The remaining portions of the barrier layer 33a may be selectively removed by wet etch process or by reactive ion etching (RIE) methods.

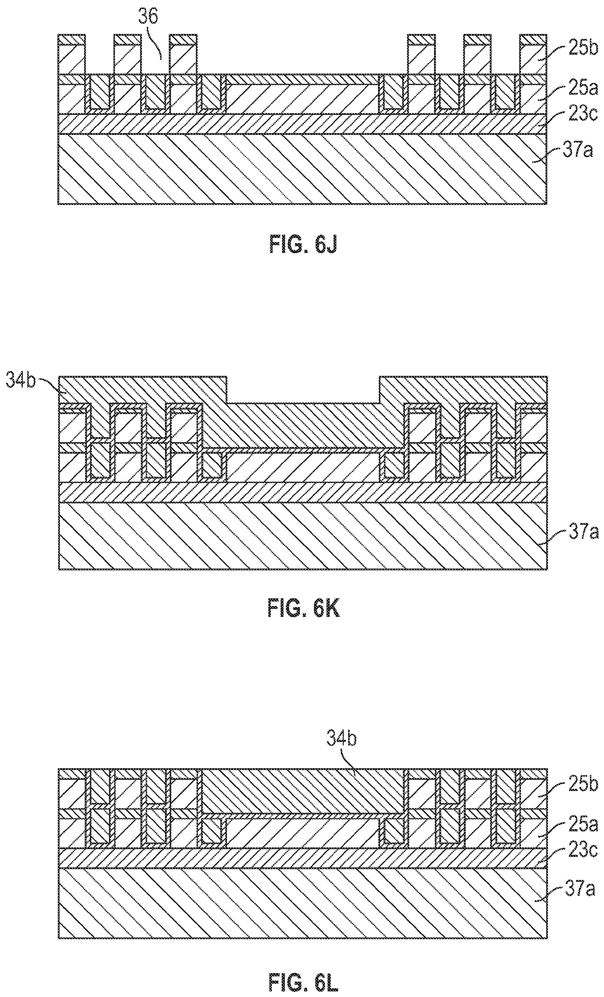

In Figure 6I, a second insulating layer 25b can be provided over the first ILD 31a and exposed upper surfaces of the first conductive material 34a. The second insulating layer 25b may comprise the same material as the first insulating layer 25a, or a different material. A second ILD 31b (which may be the same material as the first ILD 31a, or a different material) can be provided over the second insulating layer 25b. In Figure 6J, cavities 36 can be formed (*e.g.,* etched) in the second ILD 31b and second insulating layer 25b. In Figure 6K, a second conductive material 34b (*e.g.,* copper) can be provided (*e.g.,* electroplated) in the cavities 36 over a second barrier layer 33b. In Figure 6L, the second conductive material 34b can be polished. Also, as explained above, in some embodiments, multiple interconnect layers may be formed with a photodefinable polymeric material.

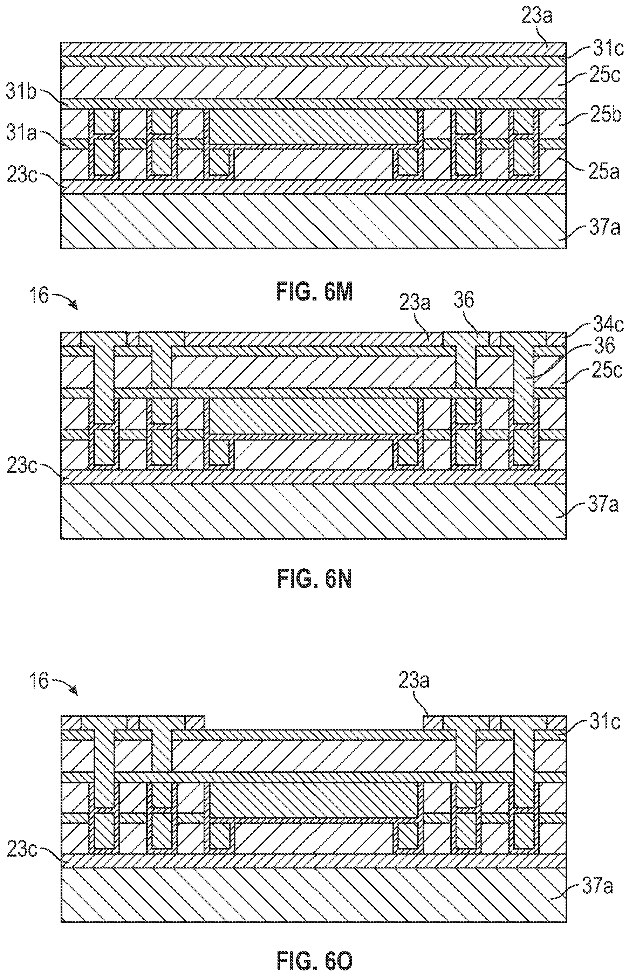

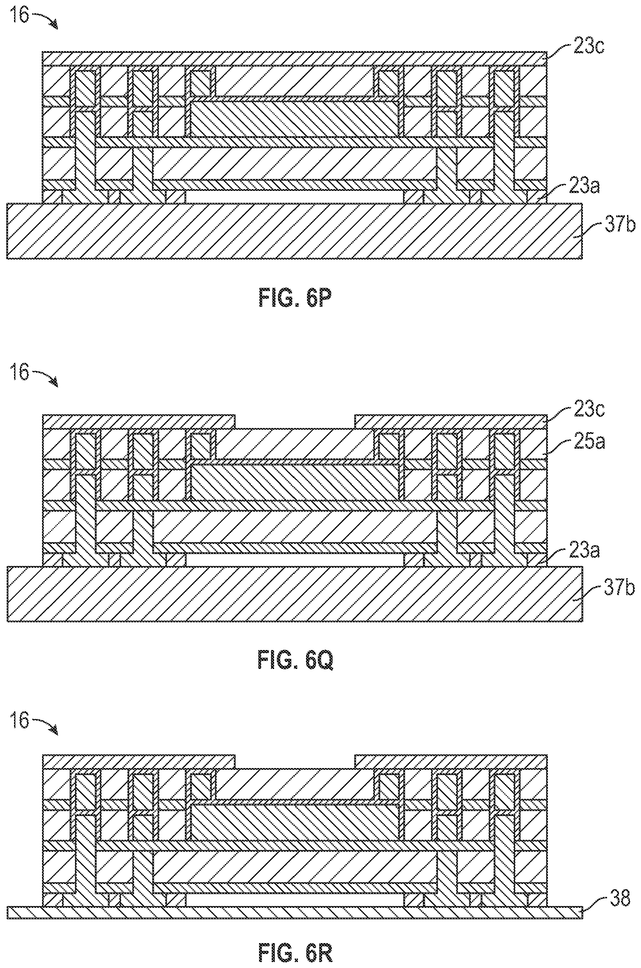

Turning to Figure 6M, a third insulating layer 25c (which may be the same as or different from the first 25a and second insulating layers 25b) can be provided over the second ILD 31b, and a third ILD 31c can be provided over the third insulating layer 25c. A frontside inorganic insulating bonding layer 23a can be provided over the third ILD 31c. The frontside inorganic insulating bonding layer 23a can comprise the same material as the backside bonding layer 23c or may comprise a different material. In Figure 6N, a third conductive material 34c can be provided in cavities 36 in the third insulating layer 25c and in the frontside bonding layer 23a. The third conductive material 34c can serve as conductive contacts 27 at the frontside of the interconnect assembly 16. In Figure 6O, a portion of the frontside bonding layer 23a can be selectively removed to expose the third ILD 31c. In Figure 6P, the interconnect assembly 16 can be flipped over and mounted to a temporary support structure 37. The temporary support 37b structure can act as a carrier, but is removed during this process. In some embodiments, the interconnect assembly 16 can be adhered to the temporary support structure 37 with an adhesive. In other embodiments, the interconnect assembly 16 can be directly bonded to the temporary support structure 37b without an intervening adhesive. The temporary support structure 37bcan also be removed (e.g., by grinding or polishing) in Figure 6P to expose the backside bonding layer 23c. In Figure 6Q, portions of the backside bonding layer 23c can be selectively removed to expose the first insulating layer 25a. In Figure 6R, the temporary support structure 37b can be removed, and the interconnect assembly 16 can be attached to a dicing sheet 38 (*e.g.,* a dicing tape in some arrangements). In some embodiments, the interconnect assembly 16 can be adhesively attached to a processing sheet and the temporary support structure 37b can be removed. In some applications, the processing sheet can comprise dicing sheet 38 and in other applications, the interconnect assembly 16 may be transferred to a dicing sheet 38 with a frame.

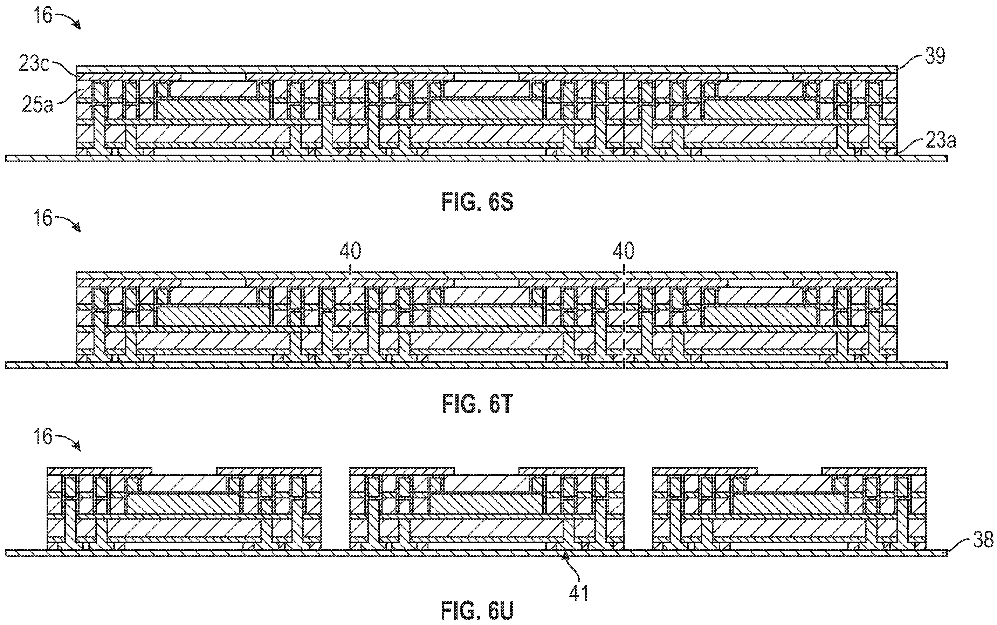

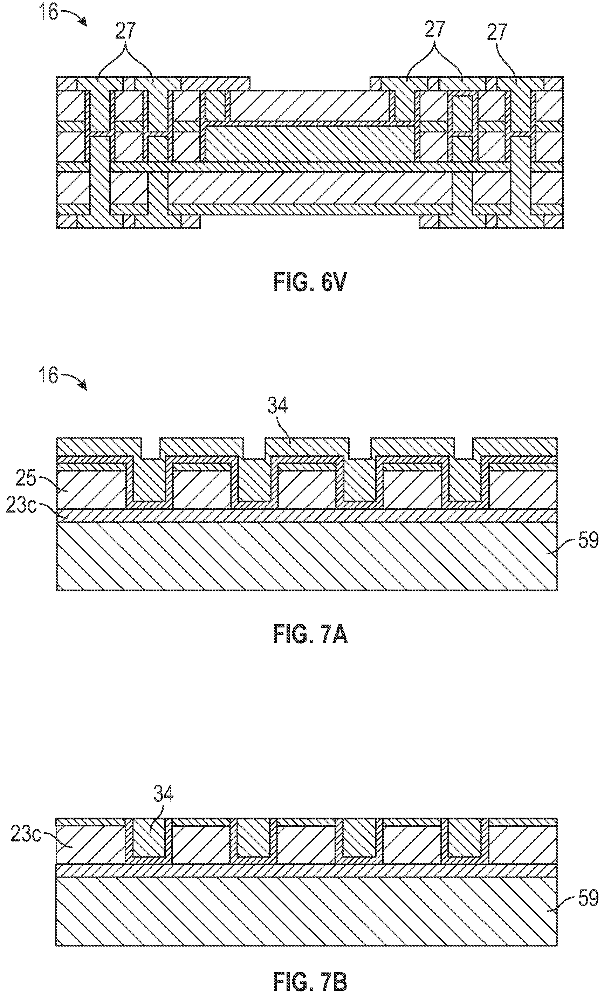

In Figure 6S, a protective layer 39 (such as an organic protective layer) can be provided over the backside bonding layer 23c. The protective layer 39 can serve to protect the bonding surface 18 of the bonding layer 25a during singulation. In some embodiments, the protective layer 39 may comprise a photoresist layer. The singulation process, for example, may comprise wet etching methods, reactive ion etching (RIE) methods, saw dicing, laser dicing and any combinations thereof. In Figure 6T, the interconnect assembly 16 can be singulated along saw streets 40 to form a plurality of singulated interconnect assemblies 16 as shown in Figure 6U. In Figure 6U, the protective layer 39 can be removed by a suitable cleaning solution such as a resist developer, and the bonding layers 23 can be prepared for direct bonding. The preparation process may comprise stripping residues of protective layer 39, cleaning unwanted particulates, ashing and activating the cleaned bonding surfaces 41,rinsing the bonding surfaces 41 with deionized water or other suitable solvent(s) and drying the cleaned bonding surfaces 41. The drying of the cleaned bonding surface 41 may comprise spin drying the rinsed interconnect assembly 16, *e.g.,* spin drying the rinsed interconnect assembly 16 at a speed between 500 to 3000 rpm, for times ranging between 15s to 240s. The higher the rpm, the shorter the drying times. After the drying step, in some embodiment the backside of the dicing frame (not shown) may be exposed to UV radiation to reduce the adhesion between the interconnect assembly 16 and the dicing sheet 38, for pick and place bonding operation. Figure 6V illustrates a singulated interconnect assembly 16 having conductive contact features 27 at least partially embedded in the frontside and backside dielectric bonding layers 23.

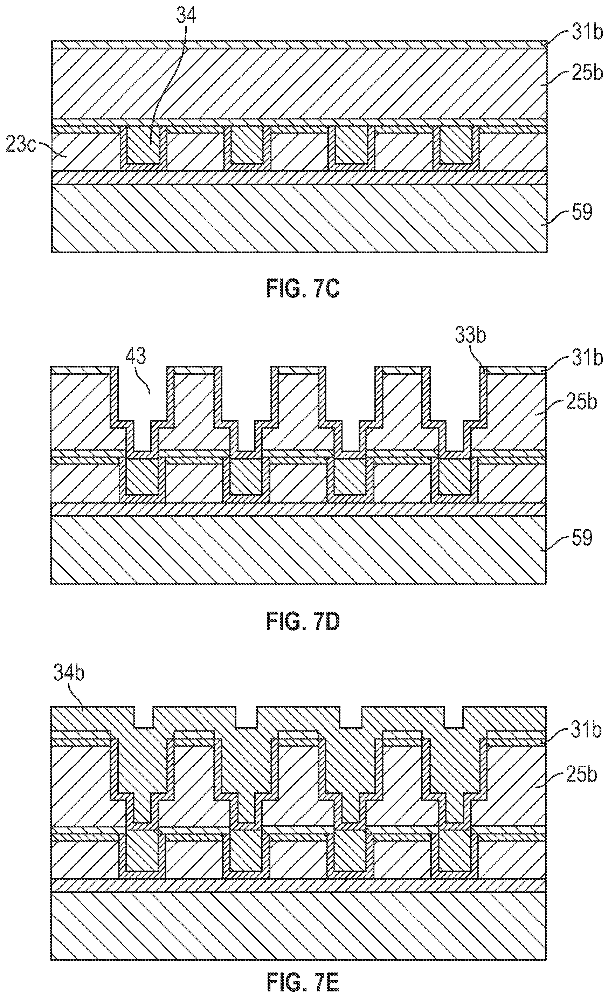

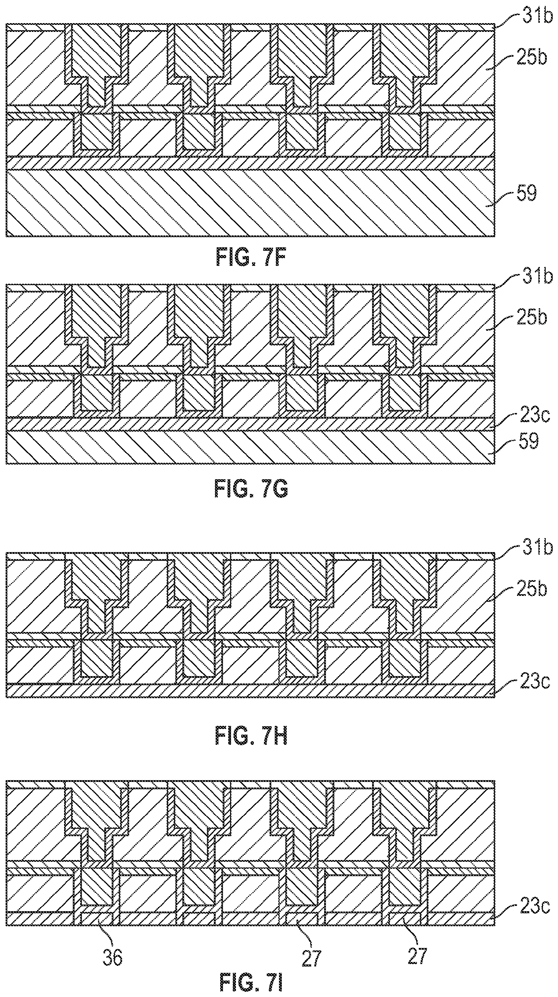

Figures 7A-7I illustrate examples of a dual damascene process. Figures 7A-7C may be the same as or generally similar to the steps shown in Figures 6G-6I. The backside bonding dielectric layer 23c may comprise embedded conductive pads at the backside bonding surface (not shown) for direct hybrid bonding. In Figure 7D, however, dual damascene cavities 43 can be formed in the second insulating layer 25b, and a barrier layer 33b can be provided in the dual damascene cavities 43. In Figure 7E, a second conductive material 34b can be provided in the dual damascene cavities 43, and, in Figure 7F, the second conductive material 34b can be planarized, with portions of the second barrier layer 33b that overlie the second ILD 31b being removed. The planarization process of Figure 7F may also planarize the second ILD 31b, which can serve as a bonding surface 18 in the illustrated embodiment. Thus, in Figure 7F, the second ILD 31b can comprise an inorganic insulating bonding layer 23, such as silicon oxide, silicon nitride, etc. In Figure 7G, the temporary substrate 59 can be thinned on the backside (if suitable for the particular process or structure). In Figure 7H, the temporary substrate 59 (*e.g.,* the temporary substrate) can be removed, and the backside inorganic bonding layer 23c can be exposed. In Figure 7I, conductive contact features 27 can be provided in cavities 36 formed in the backside bonding layer 23c, and the backside bonding layer 23c and contact features 27 can be prepared for direct bonding. In some embodiments, the stress from the frontside metallization (Cu) and overall warp in the resulting structure may be compensated for by using an aluminum (Al) metal layer within the dielectric on the backside. Al is more tensile than Cu and may be used to balance compressive stresses in the dielectric. The aluminum can be added with a buildup layer and/or CMP aluminum process. In a build-up aluminum process, the aluminum can be patterned, the dielectric can be deposited over the build-up aluminum layer and the aluminum shrinks to become more tensile to compensate for the dielectric stress. The aluminum may be exposed through an etch or a dielectric CMP polish process. A Cu bonding layer may be formed over the aluminum interconnect.

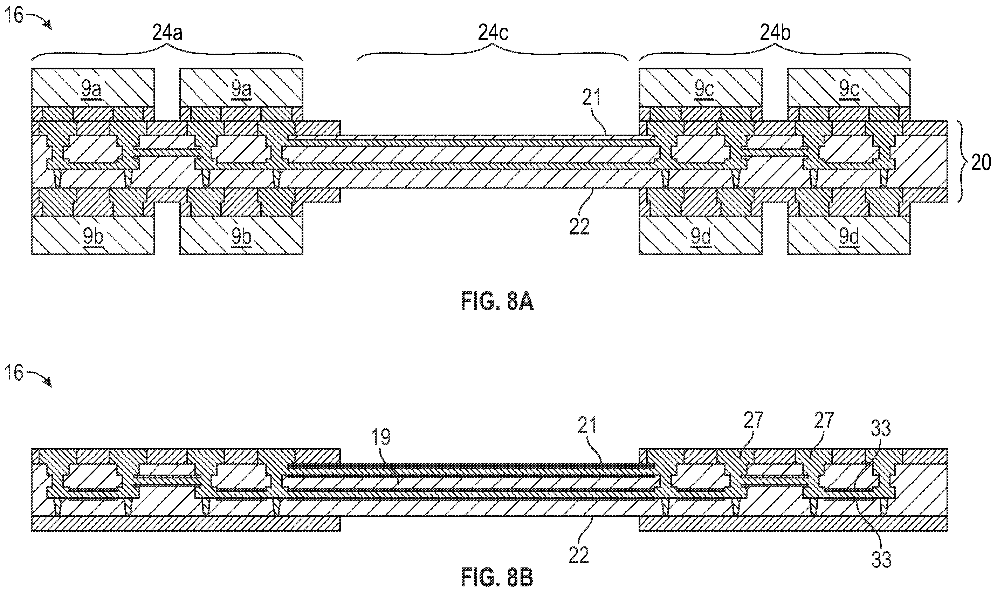

Figures 8A-8F illustrate additional examples of interconnect assemblies 16 used in bonded structures 8. Figure 8A illustrates a plurality of semiconductor elements 9a and 9c (*e.g.,* device dies) mounted on a first surface 21 of the insulating substrate 20 and a plurality of semiconductor elements 9b and 9d mounted on a second surface 22, the second surface 22 opposite the first surface 21 of the insulating substrate 20. One or a plurality of semiconductor elements 9a can be mounted on the first surface 21 of the first section 24a, and one or a plurality of semiconductor elements 9b can be mounted on the second surface 22 of the first section 24a. One or a plurality of semiconductor elements 9c can be mounted on the first surface 21 of the second section 24b. One or a plurality of semiconductor elements 9d can be mounted on the second surface 22 of the second section 24b.

Turning to Figure 8B, in some embodiments, the conductive trace(s) 19 can be encapsulated in a barrier layer 33. The barrier layer 33 can prevent moisture from contacting the conductive trace(s) 27. The barrier layer 33 can comprise any suitable type of barrier material, such as CoP, NiP, CoP/NiP, nickel vanadium, tantalum nitride, tantalum, and combinations thereof.

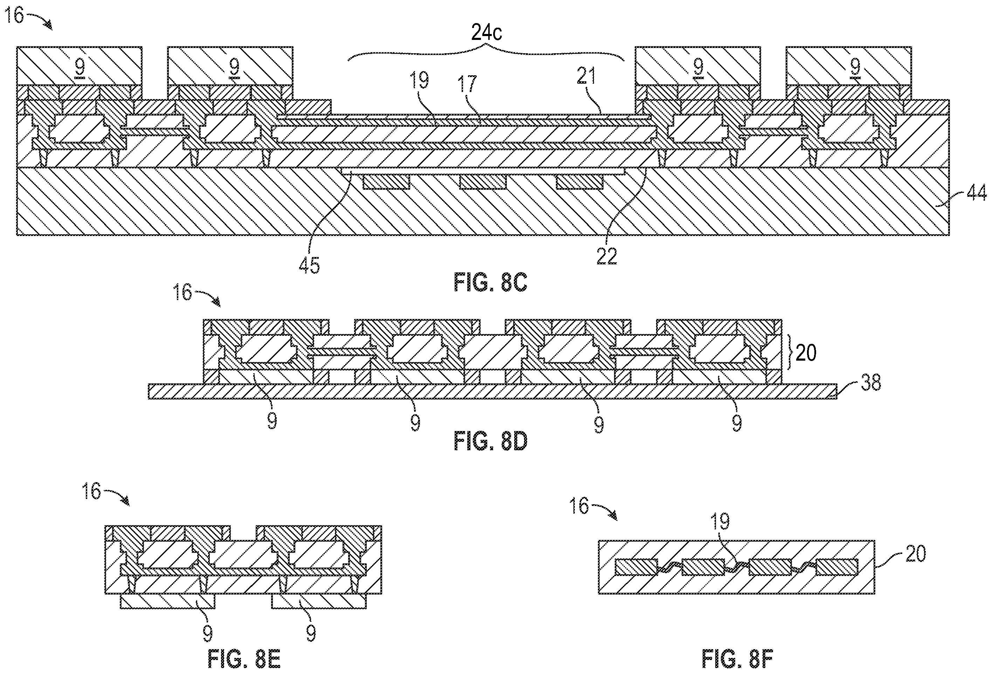

In Figure 8C, the interconnect assembly 16 can be mounted to a support structure 44 comprising a carrier 10 that includes a recess 45. The third section 24c including the flexible unit 17 can at least partially bridge the recess 45. As shown, semiconductor elements 9 can be mounted (*e.g.,* direct bonded) to the opposing side of the interconnect assembly 16 as explained above.

Figure 8D illustrates an insulating substrate 20 with semiconductor elements 9 bonded thereto and attached to a dicing sheet 38. Figure 8E illustrates a singulated interconnect assembly 16 with semiconductor elements 9 bonded thereto. Figure 8F shows a top plan view of the interconnect assembly 16. As shown in the top plan view of the interconnect assembly 16 in Figure 8F, at least one conductive trace 19 can be curved or zigzagged. The curves or zigzags can be used to relieve stress in the metal layers of the substrate 20. In some embodiments, the semiconductor devices 9 can serve as a support assembly.

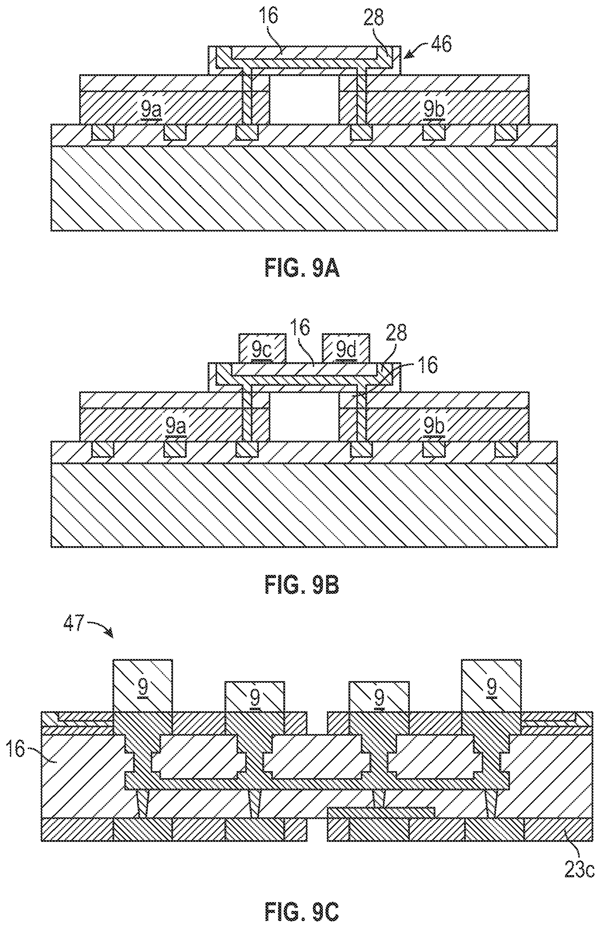

Figures 9A-9E illustrate additional embodiments that utilize a test pad 46, which can connect to a test circuit 28 disposed in the interconnect assembly 16. Unless otherwise noted, the components of Figures 9A-9E may be the same as or generally similar to like-numbered components of Figures 2C-8F. As explained above, the test circuit 28 can be configured to test a functionality of circuitry in at least one of the first 9a and second 9b semiconductor elements. Figure 9A shows a test pad 46 disposed in the interconnect assembly 16. In Figure 9B, semiconductor elements 9c and 9d can be mounted to the interconnect assembly 16 and can be connected to the test circuit 28 in the interconnect assembly 16. The suitably configured test pads 46 can test the connectivity and functionality of the various semiconductor elements 9 of Figure 9B, for example, the semiconductor elements 9 below and above the interconnect assembly 16. Figure 9C illustrates a test fixture 47 or socket for testing one or more semiconductor elements 9 bonded to the interconnect assembly 16. Multiple semiconductor elements 9 can be bonded to an interconnect assembly 16 for a functionality test. At a later time, if the tested element(s) functions correctly, the known good assembled semiconductor element(s) 9 may be bonded to another substrate via the backside bonding surface 23c of the interconnect assembly 16 to complete a module or assembly.

Figure 9D illustrates the test pad 46 connected to the carrier 10 by way of a bonding wire 48. In some embodiments, the bonding wire 48 may be adapted as power and ground conduits to the carrier 10 to supply, via the pads 46, power and ground to the semiconductor elements 9. In Figure 9E, a chiplet 49(*e.g.,* another integrated device die) can be provided in the gap 26 (e.g., directly bonded to a carrier) underneath the third section 24c including the flexible unit 17 of the interconnect assembly 16. In some embodiments, one or more chiplets 49 may be bonded to the interconnect assembly 16 (not shown).

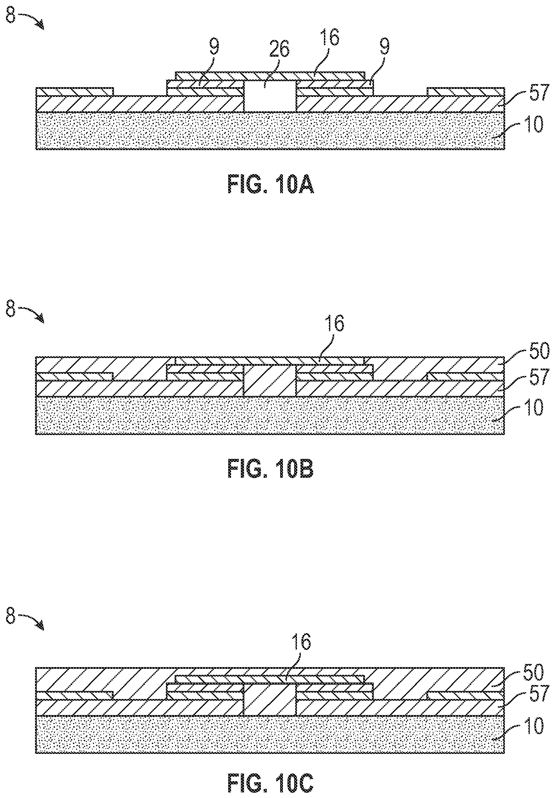

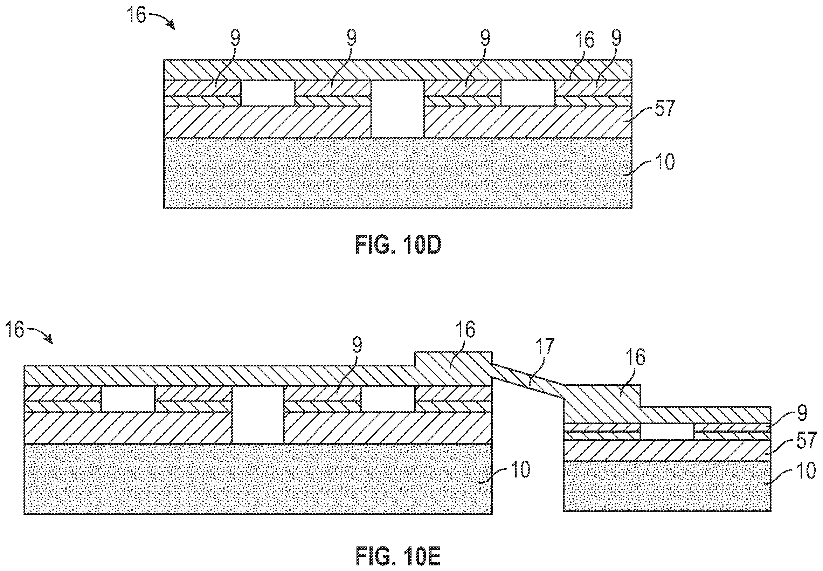

Figures 10A-10H illustrate additional examples of direct bonded structures 8 with interconnect assemblies 16. The features of Figures 10A-10E can be formed using the methods described above and, unless otherwise noted, may include components that are the same as or generally similar to the components of Figures 3A-9E. In the embodiments of Figures 3A-9E, the insulating base layer(s) 25 of the interconnect assembly 16 (which can include one or multiple layers) comprise organic materials as noted above. In the embodiments of Figures 10A-10E, however, the insulating base layer 25 can comprise an inorganic base layer. In various embodiments, the inorganic insulating base layer 25 can comprise suitable carbide materials, nitride materials, and/or oxide materials, such as glass, silicon carbide, sapphire, aluminosilicate glasses, glass ceramics, Gorilla glass^{®}, Lotus glass^{®}, diamond like carbon (DLC), or any other suitable inorganic material. A thickness of the inorganic insulating base layer can be at least 1 micron, *e.g*., in a range of 3 microns to 50 microns, or in a range of 5 microns to 20 microns. The carrier 10 can be connected to the semiconductor elements 9 by a semiconductor element 57 mounted to (e.g., directly bonded to) the carrier 10. As shown in Figures 10B-10C, in various embodiments, a molding compound 50 can be provided over the semiconductor elements 9, the carrier 10, and within the gap 26. In Figure 10B, an upper surface of the interconnect assembly 16 can be exposed through the molding compound 50. In Figure 10C, the molding compound 50 can be provided over the interconnect assembly 16. In Figure 10D shows a different configuration of the bonded structure 8 in Figure 10A where the interconnect assembly 16 is bonded with four semiconductor devices 9. Figure 10E includes a flexible unit 17 directly bonded semiconductor devices 9 with different heights.

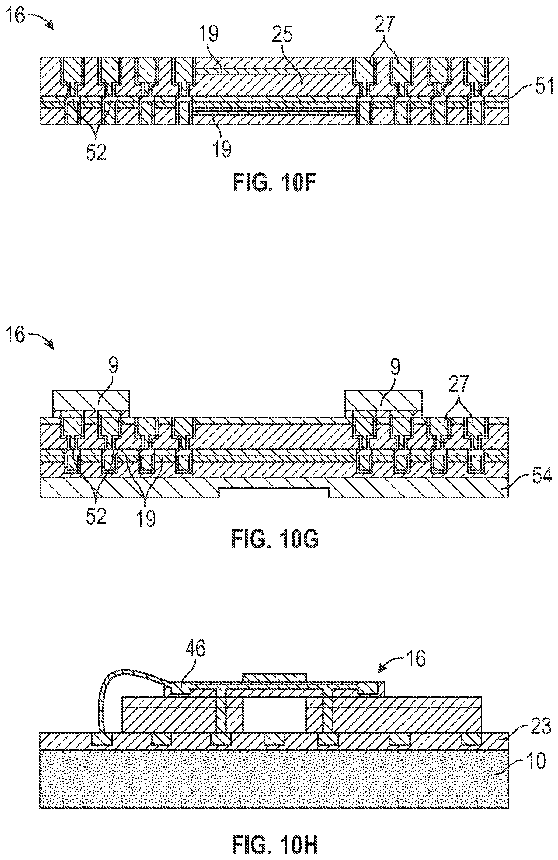

Figures 10F-10H illustrate inorganic insulating base layers 25 with a polymer stress buffer layer 51 (*e.g.,* a polyimide layer) disposed between vertically-adjacent inorganic insulating base layers 25. The buffer layer 51 can comprise pass-thru conducting vias 52 and conductive traces 19 for bridging the interconnect layer 25 above and below the buffer layer 51. The polymer buffer layers 51 can beneficially server as a stress buffer for stresses that are induced due to CTE mismatches of materials on either side of the layer, especially when the CTE of the matrix of the dielectric layer above the polymer is different from below the polymer layer. In some embodiment, the polymer buffer 51 may comprise a particulate of fiber reinforced polymer. In Fig 10G, the lower portion of the interconnect assembly 16 may be formed on a suitable substrate 54. The polymer layer 51 can comprise traces 19, pass-thru vias 52, and the inorganic bonding surface formed over the lower portion. The top portion of the interconnect assembly 16 may be formed separately in some embodiments. The lower bonding surface of the top portion of the interconnect assembly 16 can be directly bonded to the bonding surface disposed over the polymer layer 51. The temporary substrate 54 may be removed prior to subsequent processes. Figure 10G depicts a similar interconnect assembly to Figure 10F, with semiconductor devices 9 bonded to the interconnected assembly 16. Figure 10H illustrates the test pad 46 connected to the carrier 20 by way of a bonding wire 48.

### Examples of Direct Bonding Methods and Directly Bonded Structures

Various embodiments disclosed herein relate to directly bonded structures in which two elements can be directly bonded to one another without an intervening adhesive. Two or more electronic elements, which can be semiconductor elements (such as integrated device dies, wafers, etc.) or, as described herein, non-semiconductor elements such as package substrates (including flexible substrates) with inorganic insulating bonding layers, may be stacked on or bonded to one another to form a bonded structure. In the embodiments disclosed herein, the electronic component (*e.g.,* wiring layer) can comprise a first element, and the packaging carrier can comprise a second element. The semiconductor device(s) can comprise third element(s). Conductive contact pads of one element may be electrically connected to corresponding conductive contact pads of another element. Any suitable number of elements can be stacked in the bonded structure. The contact pads may comprise metallic pads formed in a nonconductive bonding region, and may be connected to underlying metallization, such as a redistribution layer (RDL).

The elements are directly bonded to one another without an adhesive. In various embodiments, a non-conductive or dielectric material of a first element is directly bonded to a corresponding non-conductive or dielectric field region of a second element without an adhesive. The non-conductive material can be referred to as a nonconductive bonding region or bonding layer of the first element. In some embodiments, the non-conductive material of the first element can be directly bonded to the corresponding non-conductive material of the second element using dielectric-to-dielectric bonding techniques. For example, dielectric-to-dielectric bonds may be formed without an adhesive using the direct bonding techniques disclosed at least in U.S. Patent Nos. 9,564,414; 9,391,143; and 10,434,749. Suitable dielectric materials for direct bonding layers as described herein include but are not limited to inorganic dielectrics, such as silicon oxide, silicon nitride, or silicon oxynitride, or can include carbon, such as silicon carbide, silicon oxycarbonitride, silicon carbonitride or diamond-like carbon. In some embodiments, the dielectric materials of the bonding layers do not comprise polymer materials, such as epoxy, resin or molding materials, although underlying layers may comprise organic materials, such as the organic insulating layer(s) described herein.

In various embodiments, hybrid direct bonds can be formed without an intervening adhesive. For example, dielectric bonding surfaces can be polished to a high degree of smoothness. The bonding surfaces can be cleaned and exposed to a plasma and/or etchants to activate the surfaces. In some embodiments, the surfaces can be terminated with a species after activation or during activation (*e.g.,* during the plasma and/or etch processes). Without being limited by theory, in some embodiments, the activation process can be performed to break chemical bonds at the bonding surface, and the termination process can provide additional chemical species at the bonding surface that improves the bonding energy during direct bonding. In some embodiments, the activation and termination are provided in the same step, *e.g.,* a plasma or wet etchant to activate and terminate the surfaces. In other embodiments, the bonding surface can be terminated in a separate treatment to provide the additional species for direct bonding. In various embodiments, the terminating species can comprise nitrogen. Further, in some embodiments, the bonding surfaces can be exposed to fluorine. For example, there may be one or multiple fluorine peaks near layer and/or bonding interfaces. Thus, in the directly bonded structures, the bonding interface between two dielectric materials can comprise a very smooth interface with higher nitrogen content and/or fluorine peaks at the bonding interface. Additional examples of activation and/or termination treatments may be found throughout U.S. Patent Nos. 9,564,414; 9,391,143; and 10,434,749.

In various embodiments, conductive contact pads of the first element can also be directly bonded to corresponding conductive contact pads of the second element. For example, a hybrid direct bonding technique can be used to provide conductor-to-conductor direct bonds along a bond interface that includes covalently direct bonded dielectric-to-dielectric surfaces, prepared as described above. In various embodiments, the conductor-to-conductor (*e.g.,* contact pad to contact pad) direct bonds and the dielectric-to-dielectric hybrid bonds can be formed using the direct bonding techniques disclosed at least in U.S. Patent Nos. 9,716,033 and 9,852,988.

For example, dielectric bonding surfaces of the bonding layers described herein can be prepared and directly bonded to one another without an intervening adhesive as explained above. Conductive contact pads (which may be surrounded by nonconductive dielectric field regions) may also directly bond to one another without an intervening adhesive. In some embodiments, the respective contact pads can be recessed below exterior (*e.g.,* upper) surfaces of the dielectric field or nonconductive bonding regions, for example, recessed by less than 30 nm, less than 20 nm, less than 15 nm, or less than 10 nm, for example, recessed in a range of 2 nm to 20 nm, or in a range of 4 nm to 10 nm. The nonconductive bonding regions can be directly bonded to one another without an adhesive at room temperature in some embodiments in the bonding tool described herein and, subsequently, the bonded structure can be annealed. Annealing can be performed in a separate apparatus. Upon annealing, the contact pads can expand and contact one another to form a metal-to-metal direct bond. Beneficially, the use of hybrid bonding techniques, such as Direct Bond Interconnect, or DBI^{®}, available commercially from Adeia of San Jose, CA, can enable high density of pads connected across the direct bond interface (e.g., small or fine pitches for regular arrays). In some embodiments, the pitch of the bonding pads, or conductive traces embedded in the bonding surface of one of the bonded elements, may be less 40 microns or less than 10 microns or even less than 2 microns. For some applications the ratio of the pitch of the bonding pads to one of the dimensions of the bonding pad is less than 5, or less than 3 and sometimes desirably less than 2. In other applications the width of the conductive traces embedded in the bonding surface of one of the bonded elements may range between 0.3 to 5 microns. In various embodiments, the contact pads and/or traces can comprise copper, although other metals may be suitable.

As explained herein, the first and second elements (*e.g.,* the electronic component illustrated herein as a wiring layer and the packaging carrier) can be directly bonded to one another without an adhesive, which is different from a deposition process. The first and second elements can accordingly comprise non-deposited elements. Further, directly bonded structures, unlike deposited layers, can include a defect region along the bond interface in which nanovoids are present. The nanovoids may be formed due to activation of the bonding surfaces (e.g., exposure to a plasma). As explained above, the bond interface can include concentration of materials from the activation and/or last chemical treatment processes. For example, in embodiments that utilize a nitrogen plasma for activation, a nitrogen peak can be formed at the bond interface. In embodiments that utilize an oxygen plasma for activation, an oxygen peak can be formed at the bond interface. In some embodiments, the bond interface can comprise silicon oxynitride, silicon oxycarbonitride, or silicon carbonitride. As explained herein, the direct bond can comprise a covalent bond, which is stronger than van Der Waals bonds. The bonding layers can also comprise polished surfaces that are planarized to a high degree of smoothness. For example, the bonding layers may have a surface roughness of less than 2 nm root mean square (RMS) per micron, or less than 1 nm RMS per micron.

In various embodiments, metal-to-metal bonds between the conductive features (*e.g.,* contact pads) in direct hybrid bonded structures can be joined such that conductive features grains, for example copper grains on the conductive features grow into each other across the bond interface. In some embodiments, the copper can have grains oriented along the 111 crystal plane for improved copper diffusion across the bond interface. The bond interface can extend substantially entirely to at least a portion of the bonded contact pads, such that there is substantially no gap between the nonconductive bonding regions at or near the bonded contact pads. In some embodiments, a barrier layer may be provided under the contact pads (*e.g.,* which may include copper). In other embodiments, however, there may be no barrier layer under the contact pads, for example, as described in US 2019/0096741.

In one embodiment, a bonded structure includes: a first semiconductor element; a second semiconductor element spaced apart from the first semiconductor element by a gap; and an interconnect assembly comprising an insulating substrate with conductive traces, the insulating substrate including a first section directly bonded to the first semiconductor element, a second section directly bonded to the second semiconductor element, and a flexible section disposed between the first and second sections, the flexible section at least partially bridging the gap.

The insulating substrate comprises an insulating base layer, and the conductive traces can be at least partially embedded in the insulating base layer. In some embodiments, the insulating base layer extends at least partially through the first section, the second section, and the flexible section. In some embodiments, the insulating base layer comprises a plurality of insulating layers. In some embodiments, the bonded structure can include an interlayer dielectric (ILD) layer disposed between a first insulating layer and a second insulating layer. In some embodiments, the ILD layer comprises at least one of silicon nitride and silicon oxide. In some embodiments, at least one conductive trace extends at least partially through the first section, the second section, and the flexible section. In some embodiments, the at least one conductive trace provides electrical communication between the first and second semiconductor elements. In some embodiments, the insulating base layer comprises a flexible thickness of an organic material. In some embodiments, the organic material comprises a polymer. In some embodiments, the organic material comprises at least one of a liquid crystal polymer (LCP) and a polyimide. In some embodiments, a coefficient of thermal expansion (CTE) of the organic layer is less than 12 ppm/°C. In some embodiments, the insulating base layer comprises a flexible thickness of an inorganic material. The first section comprises a first inorganic nonconductive bonding layer disposed over the insulating base layer. The second section comprises a second inorganic nonconductive bonding layer disposed over the insulating base layer, the flexible section disposed between the first and second inorganic nonconductive bonding layers. In some embodiments, the first and second inorganic nonconductive bonding layers comprise planarized bonding surfaces. In some embodiments, a first surface of the insulating substrate is directly bonded to the first and second semiconductor elements, the insulating substrate including a second surface opposite the first surface, wherein the first and second inorganic nonconductive bonding layers are disposed at the first surface of the insulating substrate. In some embodiments, the first section comprises a third inorganic nonconductive bonding layer disposed over the insulating base layer at the second surface of the insulating substrate. In some embodiments, the second section comprises a fourth inorganic nonconductive bonding layer disposed over the insulating base layer at the second surface of the insulating substrate. In some embodiments, the insulating substrate includes a plurality of conductive contact features at least partially embedded in the first inorganic nonconductive bonding layer. In some embodiments, the first inorganic nonconductive bonding layer is directly bonded to a nonconductive region of the first semiconductor element without an intervening adhesive, and wherein the plurality of conductive contact features are directly bonded to a plurality of conductive contact features of the first semiconductor element without an intervening adhesive. In some embodiments, a first surface of the insulating substrate is directly bonded to the first and second semiconductor elements, the insulating substrate including a second surface opposite the first surface, wherein the bonded structure includes a third semiconductor element directly bonded to the second surface of the insulating substrate and a fourth semiconductor element directly bonded to the second surface of the insulating substrate. In some embodiments, the bonded structure can include a second interconnect assembly comprising a second insulating substrate with conductive traces, the second insulating substrate including a first section directly bonded to the third semiconductor element, a second section directly bonded to the fourth semiconductor element, and a flexible section disposed between the first and second sections. In some embodiments, the first and second semiconductor elements are mounted on a support assembly. In some embodiments, the support assembly comprises a carrier, the first and second semiconductor elements mounted on the carrier. In some embodiments, the first and second semiconductor elements are directly bonded to the carrier without an intervening adhesive. In some embodiments, the first section is directly bonded to the first semiconductor element at a first vertical position relative to an upper surface of the support assembly and the second section is directly bonded to the second semiconductor element at a second vertical position relative to the upper surface of the support assembly, the second vertical position different from the first vertical position. In some embodiments, a first surface of the insulating substrate is directly bonded to the first and second semiconductor elements, the insulating substrate including a second surface opposite the first surface, the second surface mounted to third and fourth elements spaced apart from one another, the support assembly including the third and fourth elements. In some embodiments, the insulating substrate includes a third section directly bonded to a third semiconductor element and a second flexible section disposed between the second and third sections. In some embodiments, the interconnect assembly includes a test circuit connected to at least one of the first and second semiconductor elements, the test circuit configured to test a functionality of circuitry in at least one of the first and second semiconductor elements. In some embodiments, the test circuit is wire bonded to a carrier to which at least one of the first and second semiconductor elements is mounted. In some embodiments, at least one conductive trace is curved or zigzags, as seen from a top plan view of the interconnect assembly. In some embodiments, the gap comprises a gas. In some embodiments, the first and second semiconductor elements are at least partially embedded in a molding compound. In some embodiments, the molding compound is disposed in the gap. In some embodiments, the flexible section has a Young's modulus in a range of 2 GPa to 15 GPa. In some embodiments, the flexible section is bendable without breaking the insulating base layer and without disrupting electrical connectivity of the conductive traces.

In another embodiment, a bonded structure includes: a carrier; and an interconnect assembly comprising an insulating substrate with conductive traces, the insulating substrate including a first section and a flexible section extending from the first section, the first section including a first inorganic nonconductive bonding layer, the first inorganic nonconductive bonding layer directly bonded to the carrier without an adhesive.

The carrier comprises a first semiconductor element. The bonded structure includes a second semiconductor element, the insulating substrate including a second section including a second inorganic nonconductive bonding layer, the second inorganic nonconductive bonding layer directly bonded to the second semiconductor element without an adhesive. The carrier comprises a recess, the insulating substrate including a second section including a second inorganic nonconductive bonding layer directly bonded to the carrier, the flexible section at least partially bridging the recess in the carrier.

In another embodiment, a bonded structure includes: a support assembly having a first bonding surface and a second bonding surface; and an interconnect assembly over the support assembly, the interconnect assembly comprising an insulating substrate with conductive traces, the insulating substrate having a first section directly bonded to the first bonding surface without an adhesive, a second section directly bonded to the second bonding surface without an adhesive, and a third section extending between the first and second sections, the third section bridging a gap between the first and second bonding surfaces, the gap filled with a gas.

In some embodiments, the third section of the insulating substrate is flexible. The support assembly comprises a first semiconductor element and a second semiconductor element spaced apart from the first semiconductor element by a gap, the first semiconductor element comprising the first bonding surface and the second semiconductor element comprising the second bonding surface. In some embodiments, the first and second semiconductor elements are mounted on a carrier. In some embodiments, the support assembly comprises a carrier having a recess, the third section at least partially bridging the recess in the carrier. The insulating substrate includes an insulating base layer, wherein the first section comprises a first inorganic nonconductive bonding layer disposed over the insulating base layer, and wherein the second section comprises a second inorganic nonconductive bonding layer disposed over the insulating base layer. In some embodiments, the first bonding surface is at a first vertical position relative to the an upper surface of the support assembly, and wherein the second bonding surface is disposed at a second vertical position relative to the upper surface of the support assembly, the second vertical position different from the first vertical position.

In another embodiment, a bonded structure includes: a support assembly having a first bonding surface at a first vertical position relative to an upper surface of the support assembly and a second bonding surface disposed at a second vertical position relative to the upper surface of the support assembly, the second vertical position different from the first vertical position; and an interconnect assembly comprising an insulating substrate with conductive traces, the insulating substrate having a first section directly bonded to the first bonding surface without an adhesive, a second section directly bonded to the second bonding surface without an adhesive, and a third section extending between the first and second sections.

In some embodiments, the third section of the insulating substrate is flexible. The support assembly comprises a first semiconductor element and a second semiconductor element spaced apart from the first semiconductor element by a gap, the first semiconductor element comprising the first bonding surface and the second semiconductor element comprising the second bonding surface, the upper surface of the support assembly comprising a top surface of the first semiconductor element. In some embodiments, the first and second semiconductor elements are mounted on a carrier. In some embodiments, the support assembly comprises a carrier having a recess, the third section at least partially bridging the recess in the carrier. The insulating substrate includes an insulating base layer, wherein the first section comprises a first inorganic nonconductive bonding layer disposed over the insulating base layer, and wherein the second section comprises a second inorganic nonconductive bonding layer disposed over the insulating base layer.

In another embodiment, an interconnect assembly includes: an insulating substrate with conductive traces, the insulating substrate having a first surface and a second surface opposite the first surface; a first inorganic nonconductive bonding layer on a first section of the first surface of the insulating substrate, the first inorganic nonconductive bonding layer prepared for direct bonding; and a second inorganic nonconductive bonding layer on a second section of the first surface of the insulating substrate, the second section spaced apart from the first section, the second inorganic nonconductive bonding layer prepared for direct bonding, wherein the insulating substrate comprises a flexible section disposed between the first and second sections.

The insulating substrate comprises an insulating base layer, the conductive traces at least partially embedded in the insulating base layer. In some embodiments, the insulating base layer extends at least partially through the first section, the second section, and the flexible section. In some embodiments, at least one conductive trace extends at least partially through the first section, the second section, and the flexible section. In some embodiments, the insulating base layer comprises a flexible thickness of an organic material. In some embodiments, the organic material comprises a polymer. In some embodiments, the organic material comprises at least one of a liquid crystal polymer (LCP) and a polyimide. In some embodiments, a coefficient of thermal expansion (CTE) of the organic layer is less than 12 ppm/°C. In some embodiments, the insulating base layer comprises a flexible thickness of an inorganic material. The first inorganic nonconductive bonding layer is disposed over the insulating base layer. The second inorganic nonconductive bonding layer is disposed over the insulating base layer. In some embodiments, the first and second inorganic nonconductive bonding layers comprise planarized bonding surfaces. In some embodiments, the first and second inorganic nonconductive bonding layers comprise activated bonding surfaces.

In another embodiment, an interconnect assembly includes: an insulating substrate with at least one conductive trace, the insulating substrate having a first section, a second section, and a third section bridging the first and second sections; an inorganic first bonding layer on the first section of the insulating substrate, the first bonding layer prepared for direct bonding; and an inorganic second bonding layer on the second section of the insulating substrate, the second bonding layer prepared for direct bonding and laterally spaced from the first bonding layer by a gap overlying the third section.

In some embodiments, the insulating substrate includes an insulating base layer comprising a flexible thickness of an organic material. In some embodiments, the insulating base layer comprises a flexible thickness of an inorganic material. In some embodiments, the third section of the insulating substrate is flexible.

A method can include: providing an insulating layer with at least one conductive trace, the insulating layer having a first section, a second section, and a third section bridging the first and second sections; providing an inorganic first bonding layer on the first section of the insulating layer; providing an inorganic second bonding layer on the second section of the insulating layer; and preparing the inorganic first and second bonding layers for direct bonding.

The third section of the insulating layer can be flexible. The method can include providing a blanket inorganic bonding layer on a carrier substrate and providing the insulating layer on the blanket inorganic bonding layer. The method can include patterning the blanket inorganic bonding layer, the patterned inorganic bonding layer comprising the inorganic first and second bonding layers. The method can include providing a first interlayer dielectric (ILD) layer on the insulating layer. The method can include patterning cavities in the insulating layer and providing a conductive material in the cavities. The method can include polishing the conductive material. The method can include providing a second insulating layer over the first insulting layer and the conductive material. The method can include providing a second interlayer dielectric (ILD) layer on the second insulating layer. The method can include forming second cavities in the second insulating layer and providing a second conductive material in the second cavities. The method can include polishing the second conductive material. The method can include polishing the second conductive material comprises preparing the second ILD layer for direct bonding. The second ILD layer can comprise the inorganic first and second bonding layers. The method can include patterning conductive contacts in the first and second bonding layers. The method can include directly bonding the first bonding layer to a first semiconductor element without an intervening adhesive and directly bonding the second bonding layer to a second semiconductor element without an intervening adhesive. The method can include preparing the inorganic first and second bonding layers comprises planarizing the inorganic first and second bonding surfaces, the inorganic first and second bonding surfaces including an embedded conductive layer.

Unless the context clearly requires otherwise, throughout the description and the claims, the words "comprise," "comprising," "include," "including" and the like are to be construed in an inclusive sense, as opposed to an exclusive or exhaustive sense; that is to say, in the sense of "including, but not limited to." The word "coupled", as generally used herein, refers to two or more elements that may be either directly connected, or connected by way of one or more intermediate elements. Likewise, the word "connected", as generally used herein, refers to two or more elements that may be either directly connected, or connected by way of one or more intermediate elements. Additionally, the words "herein," "above," "below," and words of similar import, when used in this application, shall refer to this application as a whole and not to any particular portions of this application. Moreover, as used herein, when a first element is described as being "on" or "over" a second element, the first element may be directly on or over the second element, such that the first and second elements directly contact, or the first element may be indirectly on or over the second element such that one or more elements intervene between the first and second elements. Where the context permits, words in the above Detailed Description using the singular or plural number may also include the plural or singular number respectively. The word "or" in reference to a list of two or more items, that word covers all of the following interpretations of the word: any of the items in the list, all of the items in the list, and any combination of the items in the list.

Moreover, conditional language used herein, such as, among others, "can," "could," "might," "may," "e.g.," "for example," "such as" and the like, unless specifically stated otherwise, or otherwise understood within the context as used, is generally intended to convey that certain embodiments include, while other embodiments do not include, certain features, elements and/or states. Thus, such conditional language is not generally intended to imply that features, elements and/or states are in any way required for one or more embodiments.

## Claims

1. A bonded structure comprising:
a first semiconductor element (9);
a second semiconductor element (9) spaced apart from the first semiconductor element by a gap (26); and
an interconnect assembly (16) comprising an insulating substrate (20) comprising an insulating base layer (25) and conductive traces (19), the insulating substrate including:
a first section (24a) comprising a first inorganic nonconductive bonding layer (23a) over the insulating base layer, the first inorganic nonconductive bonding layer directly bonded to the first semiconductor element without an adhesive,
a second section (24b) comprising a second inorganic nonconductive bonding layer (23b) over the insulating base layer, the second inorganic nonconductive bonding layer directly bonded to the second semiconductor element without an adhesive, and
a flexible section (17) disposed between the first and second sections, the flexible section at least partially bridging the gap,
wherein the first inorganic nonconductive bonding layer (23a) is spaced apart from the second inorganic nonconductive bonding layer (23b).

2. The bonded structure of Claim 1, wherein the conductive traces (19) are at least partially embedded in the insulating base layer (25).

3. The bonded structure of Claim 1, wherein the insulating base layer (25) extends at least partially through the first section (24a), the second section (24b), and the flexible section (17).

4. The bonded structure of any one of Claims 1 to 3, wherein the insulating base layer comprises a plurality of insulating layers (25a, 25b, 25c).

5. The bonded structure of Claim 4, further comprising an interlayer dielectric, ILD, layer (31a, 31b) disposed between a first insulating layer (25a, 25b) and a second insulating layer (25b-25c) of the plurality of insulating layers.

6. The bonded structure of any one of Claims 1 to 5, wherein at least one conductive trace (19) extends at least partially through the first section (24a), the second section (24b), and the flexible section (17).

7. The bonded structure of Claim 6, wherein the at least one conductive trace (19) provides electrical communication between the first and second semiconductor elements (9).

8. The bonded structure of any one of Claims 2 to 7, wherein the insulating base layer (25) comprises a flexible thickness of an organic material.

9. The bonded structure of any one of Claims 1 to 8, wherein the flexible section (17) comprises a portion of the insulating base layer (25) disposed between the first and second inorganic nonconductive bonding layers (23a, 23b).

10. The bonded structure of Claim 9, wherein a first surface (21) of the insulating substrate (20) is directly bonded to the first and second semiconductor elements (9), the insulating substrate including a second surface (22) opposite the first surface, wherein the first and second inorganic nonconductive bonding layers (23a, 23b) are disposed at the first surface (21) of the insulating substrate (20).

11. The bonded structure of Claim 10, wherein the first section (24a) comprises a third inorganic nonconductive bonding layer (23c) disposed over the insulating base layer (25) at the second surface (22) of the insulating substrate (20).

12. The bonded structure of any one of Claims 1 to 11, wherein the insulating substrate (20) includes a plurality of conductive contact features (27) at least partially embedded in the first inorganic nonconductive bonding layer (23a).

13. The bonded structure of any one of Claims 1 to 12, wherein the insulating substrate (20) includes a third section directly bonded to a third semiconductor element and a second flexible section disposed between the second and third sections.

14. The bonded structure of any one of Claims 1 to 13, wherein the interconnect assembly (16) includes a test circuit (28) connected to at least one of the first and second semiconductor elements (9), the test circuit configured to test a functionality of circuitry in at least one of the first and second semiconductor elements.

15. The bonded structure of any one of Claims 1 to 14, wherein first and second semiconductor elements (9a, 9b) are mounted on a common support assembly comprising a carrier (10) vertically separated from the insulating substrate (20), and the first and second semiconductor elements are directly bonded to the carrier without an intervening adhesive.

## Patentansprüche

1. Eine gebondete Struktur, die Folgendes beinhaltet:
ein erstes Halbleiterelement (9);
ein zweites Halbleiterelement (9), das von dem ersten Halbleiterelement durch einen Spalt (26) beabstandet ist; und
eine Verbindungsanordnung (16), die ein isolierendes Substrat (20) beinhaltet, das eine isolierende Basisschicht (25) und Leiterbahnen (19) beinhaltet, wobei das isolierende Substrat Folgendes umfasst:
einen ersten Abschnitt (24a), der eine erste anorganische nichtleitende Bondingschicht (23a) über der isolierenden Basisschicht beinhaltet, wobei die erste anorganische nichtleitende Bondingschicht direkt an das erste Halbleiterelement ohne einen Klebstoff gebondet ist,
einen zweiten Abschnitt (24b), der eine zweite anorganische nichtleitende Bondingschicht (23b) über der isolierenden Basisschicht beinhaltet, wobei die zweite anorganische nichtleitende Bondingschicht direkt an das zweite Halbleiterelement ohne einen Klebstoff gebondet ist, und
einen flexiblen Abschnitt (17), der zwischen dem ersten und dem zweiten Abschnitt angeordnet ist, wobei der flexible Abschnitt den Spalt mindestens teilweise überbrückt,
wobei die erste anorganische nichtleitende Bondingschicht (23a) von der zweiten anorganischen nichtleitenden Bondingschicht (23b) beabstandet ist.

2. Gebondete Struktur gemäß Anspruch 1, wobei die Leiterbahnen (19) mindestens teilweise in die isolierende Basisschicht (25) eingebettet sind.

3. Gebondete Struktur gemäß Anspruch 1, wobei sich die isolierende Basisschicht (25) mindestens teilweise durch den ersten Abschnitt (24a), den zweiten Abschnitt (24b) und den flexiblen Abschnitt (17) erstreckt.

4. Gebondete Struktur gemäß einem der Ansprüche 1 bis 3, wobei die isolierende Basisschicht eine Vielzahl von isolierenden Schichten (25a, 25b, 25c) beinhaltet.

5. Gebondete Struktur gemäß Anspruch 4, die ferner eine Zwischenschicht-DielektrikumSchicht, ILD-Schicht, (31a, 31b) beinhaltet, die zwischen einer ersten isolierenden Schicht (25a, 25b) und einer zweiten isolierenden Schicht (25b-25c) der Vielzahl von isolierenden Schichten angeordnet ist.

6. Gebondete Struktur gemäß einem der Ansprüche 1 bis 5, wobei sich mindestens eine Leiterbahn (19) mindestens teilweise durch den ersten Abschnitt (24a), den zweiten Abschnitt (24b) und den flexiblen Abschnitt (17) erstreckt.

7. Gebondete Struktur gemäß Anspruch 6, wobei die mindestens eine Leiterbahn (19) eine elektrische Kommunikation zwischen dem ersten und dem zweiten Halbleiterelement (9) bereitstellt.

8. Gebondete Struktur gemäß einem der Ansprüche 2 bis 7, wobei die isolierende Basisschicht (25) eine flexible Dicke eines organischen Materials beinhaltet.

9. Gebondete Struktur gemäß einem der Ansprüche 1 bis 8, wobei der flexible Abschnitt (17) einen Teil der isolierenden Basisschicht (25) beinhaltet, der zwischen der ersten und der zweiten anorganischen nichtleitenden Bondingschicht (23a, 23b) angeordnet ist.

10. Gebondete Struktur gemäß Anspruch 9, wobei eine erste Oberfläche (21) des isolierenden Substrats (20) direkt an das erste und das zweite Halbleiterelement (9) gebondet ist, wobei das isolierende Substrat eine zweite Oberfläche (22) gegenüber der ersten Oberfläche umfasst, wobei die erste und die zweite anorganische nichtleitende Bondingschicht (23a, 23b) an der ersten Oberfläche (21) des isolierenden Substrats (20) angeordnet sind.

11. Gebondete Struktur gemäß Anspruch 10, wobei der erste Abschnitt (24a) eine dritte anorganische nichtleitende Bondingschicht (23c) beinhaltet, die über der isolierenden Basisschicht (25) an der zweiten Oberfläche (22) des isolierenden Substrats (20) angeordnet ist.

12. Gebondete Struktur gemäß einem der Ansprüche 1 bis 11, wobei das isolierende Substrat (20) eine Vielzahl von leitfähigen Kontaktmerkmalen (27) umfasst, die mindestens teilweise in die erste anorganische nichtleitende Bondingschicht (23a) eingebettet sind.

13. Gebondete Struktur gemäß einem der Ansprüche 1 bis 12, wobei das isolierende Substrat (20) einen dritten Abschnitt, der direkt an ein drittes Halbleiterelement gebondet ist, und einen zweiten flexiblen Abschnitt, der zwischen dem zweiten und dem dritten Abschnitt angeordnet ist, umfasst.

14. Gebondete Struktur gemäß einem der Ansprüche 1 bis 13, wobei die Verbindungsanordnung (16) eine Testschaltung (28) umfasst, die mit mindestens einem von dem ersten und dem zweiten Halbleiterelement (9) verbunden ist, wobei die Testschaltung konfiguriert ist, um eine Funktionalität einer Schaltung in mindestens einem von dem ersten und dem zweiten Halbleiterelement zu testen.

15. Gebondete Struktur gemäß einem der Ansprüche 1 bis 14, wobei das erste und das zweite Halbleiterelement (9a, 9b) auf einer gemeinsamen Trägeranordnung montiert sind, die einen Träger (10) beinhaltet, der vertikal von dem isolierenden Substrat (20) getrennt ist, und das erste und das zweite Halbleiterelement direkt an den Träger ohne einen dazwischenliegenden Klebstoff gebondet sind.

## Revendications

1. Une structure liée comprenant :
un premier élément semi-conducteur (9) ;
un deuxième élément semi-conducteur (9) espacé du premier élément semi-conducteur par un intervalle (26) ; et
un ensemble d'interconnexion (16) comprenant un substrat isolant (20) comprenant une couche de base isolante (25) et des pistes conductrices (19), le substrat isolant incluant :
une première section (24a) comprenant une première couche de liaison inorganique non conductrice (23a) au-dessus de la couche de base isolante, la première couche de liaison inorganique non conductrice étant directement liée au premier élément semi-conducteur sans adhésif,
une deuxième section (24b) comprenant une deuxième couche de liaison inorganique non conductrice (23b) au-dessus de la couche de base isolante, la deuxième couche de liaison inorganique non conductrice étant directement liée au deuxième élément semi-conducteur sans adhésif, et
une section flexible (17) disposée entre les première et deuxième sections, la section flexible enjambant au moins partiellement l'intervalle,
dans laquelle la première couche de liaison inorganique non conductrice (23a) est espacée de la deuxième couche de liaison inorganique non conductrice (23b).

2. La structure liée de la revendication 1, dans laquelle les pistes conductrices (19) sont au moins partiellement noyées dans la couche de base isolante (25).

3. La structure liée de la revendication 1, dans laquelle la couche de base isolante (25) s'étend au moins partiellement à travers la première section (24a), la deuxième section (24b), et la section flexible (17).

4. La structure liée de l'une quelconque des revendications 1 à 3, dans laquelle la couche de base isolante comprend une pluralité de couches isolantes (25a, 25b, 25c).

5. La structure liée de la revendication 4, comprenant en outre une couche diélectrique inter-couche, ILD, (31a, 31b) disposée entre une première couche isolante (25a, 25b) et une deuxième couche isolante (25b-25c) de la pluralité de couches isolantes.

6. La structure liée de l'une quelconque des revendications 1 à 5, dans laquelle au moins une piste conductrice (19) s'étend au moins partiellement à travers la première section (24a), la deuxième section (24b), et la section flexible (17).

7. La structure liée de la revendication 6, dans laquelle cette au moins une piste conductrice (19) fournit une communication électrique entre les premier et deuxième éléments semi-conducteurs (9).

8. La structure liée de l'une quelconque des revendications 2 à 7, dans laquelle la couche de base isolante (25) comprend une épaisseur flexible d'un matériau organique.

9. La structure liée de l'une quelconque des revendications 1 à 8, dans laquelle la section flexible (17) comprend une portion de la couche de base isolante (25) disposée entre les première et deuxième couches de liaison inorganiques non conductrices (23a, 23b).

10. La structure liée de la revendication 9, dans laquelle une première surface (21) du substrat isolant (20) est directement liée aux premier et deuxième éléments semi-conducteurs (9), le substrat isolant incluant une deuxième surface (22) opposée à la première surface, dans laquelle les première et deuxième couches de liaison inorganiques non conductrices (23a, 23b) sont disposées au niveau de la première surface (21) du substrat isolant (20).

11. La structure liée de la revendication 10, dans laquelle la première section (24a) comprend une troisième couche de liaison inorganique non conductrice (23c) disposée au-dessus de la couche de base isolante (25) au niveau de la deuxième surface (22) du substrat isolant (20).

12. La structure liée de l'une quelconque des revendications 1 à 11, dans laquelle le substrat isolant (20) inclut une pluralité de caractéristiques de contact conductrices (27) au moins partiellement noyées dans la première couche de liaison inorganique non conductrice (23a).

13. La structure liée de l'une quelconque des revendications 1 à 12, dans laquelle le substrat isolant (20) inclut une troisième section directement liée à un troisième élément semi-conducteur et une deuxième section flexible disposée entre les deuxième et troisième sections.

14. La structure liée de l'une quelconque des revendications 1 à 13, dans laquelle l'ensemble d'interconnexion (16) inclut un circuit de test (28) connecté à au moins l'un des premier et deuxième éléments semi-conducteurs (9), le circuit de test étant configuré pour tester une fonctionnalité de circuiterie dans au moins l'un des premier et deuxième éléments semi-conducteurs.

15. La structure liée de l'une quelconque des revendications 1 à 14, dans laquelle des premier et deuxième éléments semi-conducteurs (9a, 9b) sont montés sur un ensemble de support commun comprenant un support porteur (10) séparé verticalement du substrat isolant (20), et les premier et deuxième éléments semi-conducteurs sont directement liés au support porteur sans adhésif intermédiaire.
